Europäisches Patentamt

European Patent Office

Office européen des brevets

(11) Numéro de publication: **0 149 577**
**A2**

## (12) DEMANDE DE BREVET EUROPEEN

(21) Numéro de dépôt: **85400070.0**

(22) Date de dépôt: **16.01.85**

(51) Int. Cl.⁴: **H 04 B 14/02**
**G 05 B 11/28, H 03 K 7/08**

(30) Priorité: **16.01.84 FR 8401076**
**18.10.84 US 662261**

(43) Date de publication de la demande:
**24.07.85 Bulletin 85/30**

(84) Etats contractants désignés:
**AT BE CH DE FR GB IT LI LU NL SE**

(71) Demandeur: **Champavier, Louis**
**Les Gipières**
**F-06370 Mouans-Sartoux(FR)**

(72) Inventeur: **Champavier, Louis**
**Les Gipières**
**F-06370 Mouans-Sartoux(FR)**

(74) Mandataire: **Nony, Michel**
**Cabinet Nony 29, rue Cambacérès**
**F-75008 Paris(FR)**

(54) Procédé de conversion d'un signal analogique, en un signal par impulsions et procédé de conversion inverse, dispositifs de conversion pour la mise en oeuvre de ces procédés, systèmes de transmission et systèmes de commande et de régulation comprenant de tels dispositifs.

(57) Procédé de conversion d'un signal analogique (e) en un signal par impulsions (p). On commence à générer, à des instants déterminés, un premier signal étalon (h) variant à partir d'une valeur de référence. On compare, à partir desdit· instants, le signal analogique au signal étalon, et on émet une impulsion (p) lorsque la valeur du signal étalon atteint la valeur du signal analogique.

Fig. 9

EP 0 149 577 A2

0149577

<u>Procédé de conversion d'un signal analogique en un signal par</u>
<u>impulsions et procédé de conversion inverse, dispositifs de conversion</u>
<u>pour la mise en oeuvre de ces procédés, systèmes de transmission et</u>
<u>systèmes de commande et de régulation comprenant de tels dispositifs.</u>

La présente invention concerne un procédé de conversion d'un signal analogique en un signal par impulsions, un procédé de conversion inverse, des dispositifs de conversion pour la mise en oeuvre de ces procédés, des systèmes de transmission et des systèmes de commande et de régulation comportant de tels dispositifs.

On connaît essentiellement dans l'état de la technique trois familles de convertisseurs.

Les convertisseurs analogique/numérique (C.A.N.) transforment un signal analogique en un signal formé d'un certain nombre de bits (0 et 1), ou impulsions, qui représentent ensemble la valeur numérique du signal analogique à un instant donné. De nombreux types de tels convertisseurs analogique/numérique sont connus, par exemple les C.A.N. à intégration, les C.A.N. à approximation successives, les C.A.N. parallèles, ou encore les C.A.N. à comptage ou les convertisseurs tension-fréquence.

Les convertisseurs numérique/analogique (C.N.A.) ont un rôle inverse des précédents. Ils décodent l'information numérique contenue dans un mot composé d'un certain nombre de bits pour donner la valeur analogique d'un signal. Ils comprennent essentiellement les C.N.A. à résistances pondérées et les C.N.A. à échelle R-2R.

Enfin, les amplificateurs d'isolement galvanique visent à isoler électriquement deux étages d'un système et ont à cet effet leur circuit d'entrée isolé galvaniquement de la source de puissance ainsi que du circuit de sortie. Un tel isolement est recommandé dans des applications où la sécurité des personnes est en jeu, comme dans le domaine médical, ou pour des mesures qui exigent de n'être pas perturbées par l'environnement. La plupart des amplificateurs

- 2 -

**0149577**

d'isolement galvanique connus sont fondés sur des phénomènes électromagnétiques.

Des convertisseurs de ces trois familles sont appelés à coopérer dans de très nombreuses applications. Toutefois, étant fondés sur des principes totalement différents, cette coopération pose généralement des problèmes difficiles à résoudre.

Par ailleurs, un signal analogique se traduit sous forme numérique par un nombre d'impulsions relativement important si l'on souhaite une précision convenable. Or, la manipulation de ce nombre important d'impulsions présente également des difficultés.

La présente invention vise à palier ces inconvénients, en fournissant un procédé de conversion d'un signal analogique en un signal par impulsions et un procédé de conversion inverse qui soient simples dans leur conception et qui puissent être mis en oeuvre par des dispositifs aisément compatibles.

A cet effet, l'invention a tout d'abord pour objet un procédé de conversion d'un signal analogique en un signal par impulsions, caractérisé par le fait que l'on commence à générer, à des instants déterminés, un premier signal étalon variant à partir d'une valeur de référence, que l'on compare, à partir desdits instants, le signal analogique au signal étalon, et que l'on émet une impulsion lorsque la valeur du signal étalon atteint la valeur du signal analogique.

L'invention a également pour objet un procédé pour la conversion inverse, c'est-à-dire un procédé pour la conversion d'un signal par impulsions obtenu par le procédé décrit ci-dessus en un signal analogique, caractérisé par le fait que l'on commence à générer, à des instants synchronisés sur ledit signal par impulsions, un deuxième signal étalon variant à partir d'une deuxième valeur de référence, que l'on relève la valeur de ce deuxième signal étalon au moment de la réception de ladite impulsion, et que l'on mémorise cette valeur jusqu'à la réception de l'impulsion suivante.

On peut donc dès à présent constater que le signal par impulsions qui code le signal analogique est un signal "monobit", c'est-à-dire que la valeur du signal analogique est représentée par une seule impulsion.

Dans le cas où le signal analogique est une tension électrique variant en fonction du temps, ce que l'on supposera pour la suite de la présente description, la conversion directe selon l'invention est en fait une conversion tension/temps alors que la conversion inverse est une conversion temps/tension. En effet, le procédé selon l'invention revient à coder la valeur du signal analogique de tension, sous la forme du temps qui s'est écoulé depuis un instant déterminé où commence un cycle du signal étalon jusqu'à l'instant où ce signal étalon a atteint la valeur du signal analogique, instant où est émise l'impulsion.

Par conséquent, si l'on dispose d'un deuxième signal étalon, qui peut être ou ne pas être identique au premier signal étalon, et que ce deuxième signal étalon est synchronisé sur le premier signal étalon, on peut déduire inversement la valeur du signal analogique d'origine du temps qui s'est écoulé entre le début d'un cycle du deuxième signal étalon et la réception de l'impulsion émise lors de la conversion directe. Cette valeur analogique décodée est alors mise en mémoire jusqu'au moment où elle peut être actualisée lors de la réception de l'impulsion suivante.

Dans un mode de réalisation préféré de l'invention, l'impulsion est prolongée jusqu'à l'instant déterminé auquel on commence à générer le signal étalon suivant.

Ce mode de réalisation présente l'avantage que le deuxième signal étalon peut être alors synchronisé sur le premier signal étalon par les fronts arrière des impulsions. Ainsi, chaque impulsion est porteuse d'un double message : le front avant est représentatif de la valeur du signal, alors que le front arrière sert à la synchronisation de la conversion inverse. Par exemple, un cycle du deuxième signal étalon peut être initié lors de la réception de chaque front arrière de l'impulsion.

On constate par conséquent que, dans ce mode de réalisation, on effectue un codage du signal analogique par un signal par impulsions à fréquence fixe et à modulation de largeur d'impulsion.

Dans le procédé de conversion directe, le signal étalon peut être un signal périodique, lesdits instants déterminés étant alors séparés d'une durée égale à la période du signal étalon, ce qui revient à effectuer un échantillonnage à fréquence fixe.

Toutefois, dans un autre mode de réalisation, lesdits instants déterminés sont les instants où le signal étalon a atteint la valeur du signal analogique lors de la comparaison précédente.

Le fait d'utiliser un signal périodique comme signal étalon présente évidemment l'avantage de la simplicité.

Mais toute la partie du cycle du signal étalon postérieure à l'instant où ce signal étalon a atteint la valeur du signal analogique à convertir est inutilisée, puisque l'on reste alors dans l'attente du cycle suivant du signal étalon pour effectuer une nouvelle conversion. Il en résulte, lors de la conversion inverse, un signal analogique reconstitué relativement peu fidèle au signal analogique d'origine.

Si au contraire, on commence un nouveau cycle du signal étalon dès que ce signal étalon a atteint la valeur du signal analogique (à la largeur minimale de l'impulsion près), on supprime cette partie inutilisée du cycle, ce qui revient en quelque sorte à augmenter la fréquence d'échantillonnage,du moins lorsque le signal analogique a une valeur proche de la valeur de référence à partir de laquelle commence chaque cycle du signal étalon.

De même que l'on vient de voir que deux modes de réalisation peuvent être envisagés en ce qui concerne les instants déterminés auxquels débute chaque cycle du signal étalon, deux modes de réalisation peuvent également être envisagés en ce qui concerne la valeur de référence à laquelle débute ces cycles.

Cette valeur de référence peut tout d'abord être une valeur fixe ce qui conduira, comme on le verra par la suite, à un dispositif de mise en oeuvre relativement simple. Cette valeur fixe peut d'ailleurs être éventuellement modulée en fonction de tout paramètre extérieur. Toutefois, il est nécessaire à chaque cycle d'attendre pour avoir le résultat de la conversion que le signal étalon varie depuis cette valeur fixe jusqu'à la valeur du signal analogique à convertir. Lorsque ces deux valeurs sont distantes l'une de l'autre, le temps de conversion est donc relativement long. Il en résulte, lors de la conversion inverse, que la valeur échantillonnée précédente est conservée pendant toute cette durée en mémoire et que la valeur du signal analogique d'origine peut notablement s'en écarter.

C'est la raison pour laquelle, dans l'autre mode de réalisation, la valeur de référence est déterminée à partir de la valeur qu'avait le signal analogique lorsque cette dernière a été atteinte par la valeur du signal étalon lors de la comparaison précédente, c'est-à-dire qu'elle est déduite de la valeur échantillonnée au cours du cycle précédent.

Dans ce dernier cas, chaque nouveau cycle du signal étalon peut donc commencer aussi près que possible de la valeur échantillonnée précédente. Pour un signal analogique variant relativement lentement par rapport à la fréquence d'échantillonnage, il en résulte que, dans tous les cas, le signal étalon atteint rapidemment à chaque cycle la valeur du signal analogique à convertir, ce qui revient par conséquent à augmenter la fréquence d'échantillonnage.

On constate que, dans ce dernier cas, le procédé selon l'invention est un procédé auto-adaptatif puisque, à chaque cycle, la valeur de référence du signal étalon est une fonction de la valeur d'échantillonnage précédente.

Dans le mode de réalisation le plus simple du procédé auto-adaptatif décrit ci-dessus, la valeur de référence est égale à ladite valeur

- 6 -

0149577

qu'avait le signal analogique à laquelle est ajoutée algébriquement une quantité prédéterminée.

En d'autres termes la valeur de référence de chaque cycle est égale à la valeur d'échantillonnage du cycle précédent augmentée ou diminuée d'une quantité prédéterminée.

En ce qui concerne la forme du signal étalon, celui-ci peut être une rampe, mais toute autre forme, par exemple sinusoïdale ou exponentielle, peut être envisagée.

Lorsque le deuxième signal étalon utilisé lors de la conversion inverse est identique à celui utilisé lors de la conversion directe, le signal analogique reconstitué est équivalent au signal d'origine.

Toutefois, en utilisant un deuxième signal étalon différent du premier, il est particulièrement aisé d'aboutir à toute modification souhaitée du signal d'origine.

Par exemple, en utilisant deux signaux étalons proportionnels, on obtient un signal reconstitué proportionnel au signal d'origine.

Mais, des modifications plus profondes du signal d'origine peuvent également être obtenues. Si l'on considère, par exemple, un signal d'origine exponentiel et que l'on utilise un signal étalon de conversion directe également exponentiel et un deuxième signal étalon de conversion inverse sous forme de rampe, on peut aisément montrer que le signal analogique reconstitué est un signal également en forme de rampe.

Cette dernière propriété trouve des applications extrêmement intéressantes dans le domaine de la linéarisation des capteurs ou dans la commande de processus.

Une autre possibilité de modification du signal d'entrée consiste à utiliser des signaux étalons de fréquences différentes lors des conversions directe et inverse .

Lorsque le signal étalon est une rampe, il est particulièrement simple de le générer par des moyens analogiques. Toutefois, il peut être avantageux dans certains cas, en particulier pour des signaux étalons de forme complexe, de les générer par des moyens numériques.

Dans ce dernier cas, un mode de réalisation consiste à compter des signaux d'horloge dans un compteur et à convertir à chaque signal d'horloge le contenu du compteur en un signal analogique qui est ensuite utilisé comme signal étalon.

Ce dernier mode de réalisation pourra en particulier être préféré dans le cas d'un procédé auto-adaptatif tel que décrit ci-dessus, dans lequel le signal étalon n'est pas linéaire.

Il est en effet, dans ce cas, plus facile de déduire la valeur de référence de chaque cycle du signal étalon de la valeur d'échantillonnage précédente par des moyens numériques qu'analogiques. En particulier, pour ajouter algébriquement une quantité prédéterminée à la valeur d'échantillonnage précédente, il suffit de provoquer un décalage du compteur.

L'invention a également pour objet un dispositif pour la mise en oeuvre du procédé de conversion directe tel que décrit ci-dessus, caractérisé par le fait qu'il comprend un générateur de fonction pour générer le signal étalon, un comparateur pour comparer ledit signal analogique au signal étalon, et un émetteur pour émettre une impulsion lorsque le comparateur détecte l'égalité du signal analogique et du signal étalon.

L'invention a également pour objet un dispositif pour la mise en oeuvre du procédé de conversion inverse, caractérisé par le fait qu'il comprend un récepteur pour la réception des impulsions du signal par impulsions, un deuxième générateur de fonction pour générer le deuxième signal étalon, des moyens pour synchroniser ledit second signal étalon sur le premier signal étalon, et des moyens pour mémoriser la valeur atteinte par le deuxième signal étalon lors de la réception d'une impulsion.

On constate la similitude entre ces deux dispositifs alors que, par exemple, un convertisseur analogique/numérique ne présente aucun point commun avec un convertisseur numérique/analogique. En particulier, le dispositif de conversion directe et le dispositif de conversion inverse comprennent chacun un générateur de fonction qui peuvent être conçus sur les mêmes bases.

Le dispositif de conversion inverse comprend bien entendu des moyens de synchronisation afin de synchroniser le deuxième étalon sur le premier signal étalon, de manière à disposer d'une origine de temps pour situer l'instant où est reçue l'impulsion.

En outre, ce dispositif de conversion inverse comprend des moyens de mémorisation pour conserver en mémoire la valeur analogique reconstituée à chaque réception d'impulsion, jusqu'à la réception de l'impulsion suivante.

Le générateur de fonction du dispositif de conversion directe peut être en particulier un générateur de rampe à front raide, ce front raide permet d'assurer dans tous les cas une excellente synchronisation entre le générateur de fonction du dispositif de conversion inverse et le générateur de fonction du dispositif de conversion directe.

Avantageusement, le générateur de fonction est agencé pour que les valeurs d'extrémité de la rampe soient supérieures en valeur absolue à la valeur maximale dudit signal analogique.

Cet agencement permet de disposer d'un marqueur à chacune des extrémités de la rampe, de sorte que le dispositif est assuré de transmettre une impulsion à chaque cycle du signal étalon.

On constatera en outre ultérieurement que ces deux marqueurs jouent un rôle supplémentaire dans le recalage du dispositif de conversion inverse.

- 9 -

0149577

Afin de réaliser, comme cela a été mentionné précédemment, une modulation de la largeur des impulsions émises, le comparateur du dispositif de conversion directe est agencé, dans un mode de réalisation particulier, pour fournir des impulsions dont le front avant correspond à la détection de l'égalité entre le signal analogique et le signal étalon, et dont le front arrière correspond auxdits instants déterminés auxquels on commence à générer le signal étalon suivant.

Dans le cas où l'on déduit la valeur de référence du premier signal étalon de la dernière valeur d'échantillonnage, le dispositif selon l'invention peut comprendre en outre un premier échantillonneur-bloqueur à l'entrée duquel est appliqué ledit signal analogique, un deuxième échantillonneur-bloqueur à l'entrée duquel est appliquée la sortie du premier échantillonneur-bloqueur, des moyens pour faire passer le premier échantillonneur-bloqueur en mode MAINTIEN et le deuxième échantillonneur-bloqueur en mode RECOPIE lors de la détection par le comparateur de l'égalité entre le signal analogique et le signal étalon, et pour faire repasser le premier échantillonneur-bloqueur en mode RECOPIE et le deuxième échantillonneur-bloqueur en mode MAINTIEN auxdits instants déterminés auxquels on commence à générer le signal étalon suivant, et des moyens pour déduire de la sortie du deuxième échantillonneur-bloqueur ladite valeur de référence du signal étalon.

Ainsi, si l'on se place au début d'un cycle du signal étalon, le premier échantillonneur-bloqueur se trouve en mode RECOPIE de sorte que sa sortie suit le signal analogique d'entrée. Dès que le comparateur détermine que le signal étalon est devenu égal au signal analogique à convertir, il provoque l'émission d'une impulsion et, simultanément, le premier échantillonneur-bloqueur passe en mode MAINTIEN de sorte que sa sortie conserve la valeur échantillonnée. Le deuxième échantillonneur-bloqueur qui est alors en mode RECOPIE a sa sortie qui atteint progressivement cette valeur échantillonnée, à la suite de quoi la valeur de référence pour le cycle suivant du signal étalon peut être élaborée.

En particulier, ces moyens pour déduire de la sortie du deuxième échantillonneur-bloqueur ladite valeur de référence peuvent comprendre un sommateur pour ajouter algébriquement une quantité prédéterminée à ladite sortie.

Avantageusement, l'entrée du comparateur correspondant au signal analogique est reliée à la sortie du premier échantillonneur-bloqueur.

Ceci permet de garder constante la tension de comparaison du comparateur pendant toute la durée de l'impulsion.

Dans le dispositif de conversion inverse, les moyens pour mémoriser la valeur du deuxième signal étalon comprennent de préférence un troisième échantillonneur-bloqueur dont l'entrée est reliée à la sortie du deuxième générateur de fonction, et des moyens pour faire passer ce troisième échantillonneur-bloqueur en mode MAINTIEN lors de la réception de ladite impulsion et pour le faire repasser en mode RECOPIE aux instants auxquels on commence à générer le signal étalon suivant.

La sortie du troisième échantillonneur-bloqueur suit par conséquent la sortie du deuxième générateur de fonction tant que l'impulsion provenant du dispositif de conversion directe n'a pas été reçue. Puis, lors de la réception de cette impulsion, sa sortie conserve une valeur constante qui, si les deux étalons sont identiques, est égale à la dernière valeur échantillonnée dans le dispositif de conversion directe.

Les moyens pour mémoriser la valeur du deuxième signal étalon peuvent en outre comprendre un quatrième échantillonneur-bloqueur dont l'entrée est reliée à la sortie du troisième échantillonneur-bloqueur, et des moyens pour que le quatrième échantillonneur-bloqueur soit en mode RECOPIE lorsque le troisième échantillonneur-bloqueur est en mode MAINTIEN, et inversement.

Par conséquent, dès que le dispositif de conversion inverse reçoit une impulsion, la sortie du premier échantillonneur-bloqueur conserve une

- 11 -

valeur constante et la sortie du troisième échantillonneur-bloqueur recopie cette valeur et la conserve jusqu'à la réception de l'impulsion suivante. Le signal de sortie du quatrième échantillonneur-bloqueur est donc un signal analogique en escalier représentatif du signal analogique d'origine, et qui peut éventuellement être lissé si cela est souhaité.

L'invention a également pour objet un système de transmission d'un signal analogique en boucle ouverte caractérisé par le fait qu'il comprend un dispositif de conversion directe tel que décrit ci-dessus à l'entrée duquel est appliqué le signal à transmettre, un dispositif de conversion inverse tel que décrit ci-dessus, et des moyens pour coupler la sortie du dispositif de conversion directe à l'entrée du dispositif de conversion inverse.

Le signal transmis est par conséquent le signal par impulsions résultant de la conversion directe du signal analogique. Ce signal par impulsions est ensuite de nouveau converti à la réception pour restituer un signal analogique équivalent au signal analogique à transmettre.

L'invention a également pour objet un système de transmission d'un signal analogique en boucle fermée caractérisé par le fait qu'il comprend dans sa boucle directe un sommateur pour soustraire du signal à transmettre le signal transmis, un premier dispositif de conversion directe tel que décrit ci-dessus à l'entrée duquel est appliqué le signal de sortie du sommateur, un premier dispositif de conversion inverse tel que décrit ci-dessus, des moyens pour coupler la sortie du premier dispositif de conversion directe à l'entrée du premier dispositif de conversion inverse et des moyens pour boucler la sortie du premier dispositif de conversion inverse sur lui-même.

Dans ces conditions, le signal qui est effectivement transmis est uniquement la différence entre le signal transmis et le signal à transmettre. En bouclant sur lui-même la sortie du premier dispositif de conversion inverse à la réception , on restitue le signal à transmettre à partir de ce signal de différence.

0149577

Dans un mode de réalisation particulier, ce système de transmission possède dans sa boucle de retour un second dispositif de conversion directe tel que décrit ci-dessus à l'entrée duquel est appliqué le signal transmis, un second dispositif de conversion inverse tel que décrit ci-dessus dont la sortie est appliquée à l'entrée du sommateur, et des moyens pour coupler la sortie du second dispositif de conversion directe à l'entrée du second dispositif de conversion inverse.

Dans ce cas, la boucle de retour est par conséquent pratiquement identique à la boucle directe.

Il est en particulier possible de déconnecter les boucles directe et de retour et de disposer ainsi de deux systèmes de transmission en boucle ouverte.

L'invention a également pour objet un système de commande d'un organe de puissance, caractérisé par le fait qu'il comprend au moins un dispositif de conversion directe du type décrit ci-dessus, dans lequel le comparateur est agencé pour fournir des impulsions dont le front avant correspond à la détection de l'égalité entre le signal analogique et le signal étalon et dont le front arrière correspond auxdits instants déterminés auxquels on commence à générer le signal étalon suivant, des moyens pour fournir à l'entrée de ce dispositif un signal de consigne, et des moyens reliés à la sortie de ce dispositif pour connecter une source d'énergie audit organe de puissance pendant la durée des impulsions de sortie de ce dispositif et pour la déconnecter en dehors desdites impulsions.

On a vu en effet qu'un tel dispositif fournit un signal par impulsions dans lequel la largeur des impulsions est modulée par le signal d'entrée. Il en résulte que, dans un système de commande tel que décrit ci-dessus, l'organe de puissance est alternativement connecté à et déconnecté de la source d'énergie, la proportion de temps pendant lequel il est connecté à cette source étant une fonction de la valeur de consigne.

Un tel système de commande peut être par exemple appliqué à l'alimentation de résistances de chauffage ou d'un moteur électrique à courant continu, par l'intermédiaire de thyristors commandés par le dispositif selon l'invention.

L'invention a également pour objet un système de régulation comportant une boucle directe et une boucle de retour, caractérisé par le fait que la boucle directe comporte au moins un dispositif de conversion directe tel que décrit ci-dessus, et des moyens pour fournir à l'entrée de ce dispositif un signal analogique égal à la différence entre un signal de consigne et le signal de retour, ces derniers moyens comprenant avantageusement un amplificateur à gain proportionnel.

Un système de commande tel que décrit ci-dessus qui serait bouclé sur lui-même correspond sensiblement à ce système de régulation.

Dans ce cas, le signal analogique converti en un signal par impulsions est constitué par la différence entre un signal de consigne et la valeur actuelle d'une grandeur à réguler, par exemple de la température où du courant dans le moteur à courant continu dans les exemples précédents.

Un tel système de régulation peut également comprendre dans sa boucle directe un dispositif de conversion inverse tel que décrit ci-dessus et des moyens pour coupler la sortie du dispositif de conversion directe à l'entrée du dispositif de conversion inverse.

Un tel agencement peut être adopté lorsque l'on souhaite disposer en sortie d'un signal analogique représentatif du signal analogique d'entrée, ou encore lorsque l'on souhaite réaliser une isolation entre l'entrée et la sortie du système.

La régulation peut être alors assurée par le fait qu'un sommateur est disposé entre le troisième et le quatrième échantillonneur-bloqueur du dispositif de conversion inverse, pour fournir à l'entrée du quatrième échantillonneur-bloqueur un signal égal à la somme des signaux de sortie des troisième et quatrième échantillonneurs-bloqueurs.

Dans un mode de réalisation avantageux de l'invention, la boucle de retour comprend également un dispositif de conversion directe et un dispositif de conversion inverse, et des moyens pour coupler la sortie du premier de ces dispositifs à l'entrée du second.

On constate, que dans ces conditions, les boucles directe et de retour sont identiques. Cette caractéristique présente de nombreux avantages.

En effet, il est alors possible de passer instantanément d'un fonctionnement en boucle ouverte à un fonctionnement en boucle fermée. Lorsque le système fonctionne comme deux boucles ouvertes distinctes, on peut observer simultanément l'ordre et son exécution. Par contre, en fonctionnant en boucle fermée, il est possible d'assurer une régulation soit dans un sens soit dans l'autre.

On décrira maintenant, à titre d'exemples non limitatifs, divers modes de réalisation particuliers de l'invention en référence aux dessins schématiques annexés dans lesquels :

La figure 1 est un schéma électrique d'un dispositif de conversion directe selon l'invention.

Les figures 2a à 2c illustrent le fonctionnement du schéma de la figure 1.

La figure 3 est un schéma électrique d'un dispositif de conversion inverse selon l'invention.

Les figures 4a à 4d illustrent le fonctionnement du schéma de la figure 3.

La figure 5 représente un système de transmission de signaux en boucle fermée conforme à l'invention.

Les figures 6a à 6c illustrent le fonctionnement de variantes des dispositifs des figures 1 et 3.

La figure 7 illustre le fonctionnement d'un autre mode de réalisation de l'invention.

La figure 8 illustre également le fonctionnement de deux autres modes de réalisation de l'invention.

La figure 9 est un schéma représentant un dispositif de conversion directe auto-adaptatif selon l'invention.

La figure 10 est un schéma représentant un dispositif de conversion inverse auto-adaptatif conforme à l'invention.

La figure 11 illustre le fonctionnement des schémas des figures 9 et 10.

La figure 12 représente une application particulière de l'invention.

La figure 13 représente une autre application particulière de l'invention.

La figure 14 représente le cas où l'étalon est généré par des moyens numériques.

La figure 15 montre comment la valeur de référence est obtenue dans ce cas, et

la figure 16 est un diagramme d'un dispositif opérant la conversion directe par des moyens numériques.

Un récapitulatif des symboles utilisés pour les différents signaux est donné à la fin de la présente description.

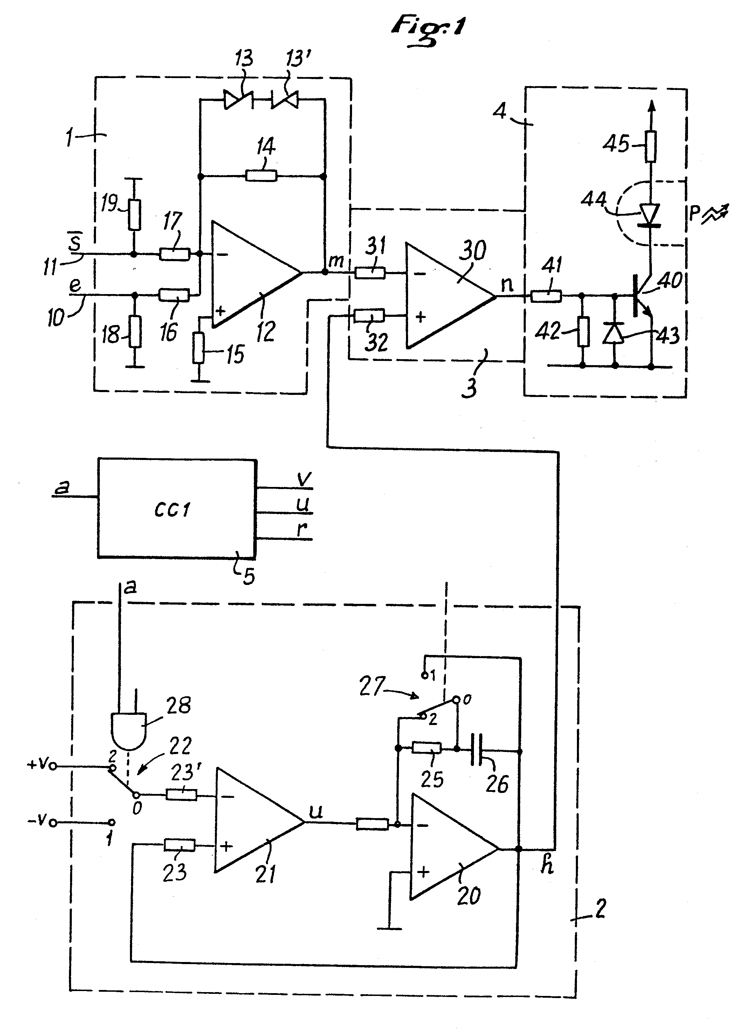

Le circuit de conversion directe représenté à la figure 1 comprend essentiellement un sommateur écrêteur 1, un générateur de rampe 2, un comparateur 3 et un transmetteur 4.

Le sommateur 1 reçoit sur une de ses entrées 10 le signal analogique (e) à convertir et, éventuellement, sur son autre entrée 11, un signal de retour ($\bar{s}$) qui sera décrit ci-après. Le transmetteur 4 émet un signal (p), par exemple un signal optique, qui est le signal par impulsions résultant de la conversion du signal d'entrée. Un circuit de commande 5 assure les différentes fonctions logiques et de synchronisation nécessaires au fonctionnement du circuit de la figure 1.

Le sommateur 1 est composé essentiellement d'un amplificateur différentiel 12 à gain proportionnel et écrêtage symétrique.

L'écrêtage est assuré par deux diodes Zener 13 et 13' montées tête-bêche et le gain est déterminé de façon classique par la résistance 14. L'ensemble constitué par les diodes Zener 13, 13' d'une part, et la résistance 14 d'autre part, sont montés de façon connue en parallèle entre la sortie de l'amplificateur 12 et son entrée négative. Son entrée positive est reliée à la masse par l'intermédiaire d'une résistance 15.

Les signaux (e) et ($\bar{s}$) sont appliqués à l'entrée négative de l'amplificateur 12 par l'intermédiaire des résistances 16 et 17 respectivement, et sont reliés à la masse par des résistances 18 et 19 qui fixent le potentiel d'entrée.

Le fonctionnement d'un circuit tel que le sommateur écrêteur 1 est bien connu, et l'on sait qu'il délivre à la sortie de l'amplificateur un signal (m) égal à la somme des signaux (e) et ($\bar{s}$) écrêté aux valeurs déterminées par les diodes Zener 13 et 13'.

Le générateur de rampe 2 est également de type connu. Il est essentiellement composé d'un amplificateur 20 monté en intégrateur, d'un autre amplificateur 21 monté en comparateur, et d'un commutateur électronique 22.

L'amplificateur 21 reçoit sur son entrée positive, par l'intermédiaire de la résistance 23, la sortie (h) de l'amplificateur 20, et sur son entrée négative, par l'intermédiaire de la résistance 23', l'une ou l'autre des tensions de référence -V ou +V en fonction de la position du commutateur 22.

La sortie (u) de l'amplificateur 21 est appliquée par l'intermédiaire d'une résistance 24 à l'entrée négative de l'amplificateur 20 dont l'entrée positive est reliée à la masse.

Enfin, une résistance 25 ou un condensateur 26 sont connectés entre l'entrée négative de l'amplificateur 20 et sa sortie, en fonction de la position d'un autre commutateur électronique 27.

Le commutateur 27 ainsi que le commutateur 22 sont pilotés par une porte logique 28.

On suppose que les commutateurs 22 et 27 sont sur (0-2) comme cela est le cas sur la figure, et que le comparateur vient de basculer en -U. Cette tension -U alimente l'intégrateur au travers de la résistance 24 de sorte que l'amplificateur 20 intègre de -V à +V .

Lorsque la tension (h) de sortie de l'amplificateur 20 atteint et dépasse +V, le comparateur 21 bascule de -U à +U et le circuit de commande 5 reçoit une impulsion.

Le circuit 5 change alors d'état et donne un ordre (a) à la porte 28 qui fait basculer les commutateurs 22 et 27 en (0-1) .

La tension -V est alors appliquée à l'entrée négative du comparateur 21 qui reste dans son état de sortie +U. Simultanément, du fait que le commutateur 27 est en position (0-1) , le condensateur 26 se décharge et la sortie (h) de l'amplificateur 20 passe pratiquement instantanément de +V à -V .

Cette tension -V est transmise par l'intermédiaire de la résistance 23 à l'entrée positive de l'amplificateur 21, et fait par conséquent basculer cette amplificateur en -U. La logique 5 change d'état et commande les portes 22 et 27 qui reviennent en (0-2). Le cycle recommence alors.

Le comparateur 3 est simplement composé d'un amplificateur 30 qui reçoit sur son entrée négative le signal de sortie (m) du sommateur 1 par l'intermédiaire de la résistance 31, et sur son entrée positive le signal de sortie (h) du générateur de rampe 2 par l'intermédiaire de la résistance 32.

Par conséquent, la sortie (n) du comparateur 3 a la valeur -N lorsque (m) est plus grand que (h) et a la valeur +N lorsque m est inférieur à (h).

Le transmetteur 4 comporte un transistor 40 dont la base est alimentée à partir du signal de sortie du comparateur 3 à travers une résistance 41.

La base du transistor 40 est reliée à la masse par l'intermédiaire d'une résistance 42 qui fixe le potentiel de base et d'une diode 43 qui sert à éliminer la partie négative du signal d'entrée du transmetteur 4. La résistance 42 et la diode 43 sont disposées en parallèle.

Une diode photo-émettrice 44 est disposée dans le circuit collecteur du transistor 40, en série avec une résistance 45 qui limite le courant à une valeur admissible par la diode.

Dans l'exemple représenté au dessin, le transmetteur 4 est un photo-coupleur mais, bien-entendu, tout autre type de transducteur pourrait être utilisé.

On constate par conséquent que la diode 44 émet des impulsions (p) présentant les mêmes caractéristiques que la partie positive du signal de sortie du comparateur 3.

Le circuit de commande 5 peut être réalisé de manière bien connue sous la forme d'une bascule R-S recevant en entrée, outre les tensions (v) et (u) , un signal de validation (r) permettant de synchroniser le générateur de fonction avec une horloge externe.

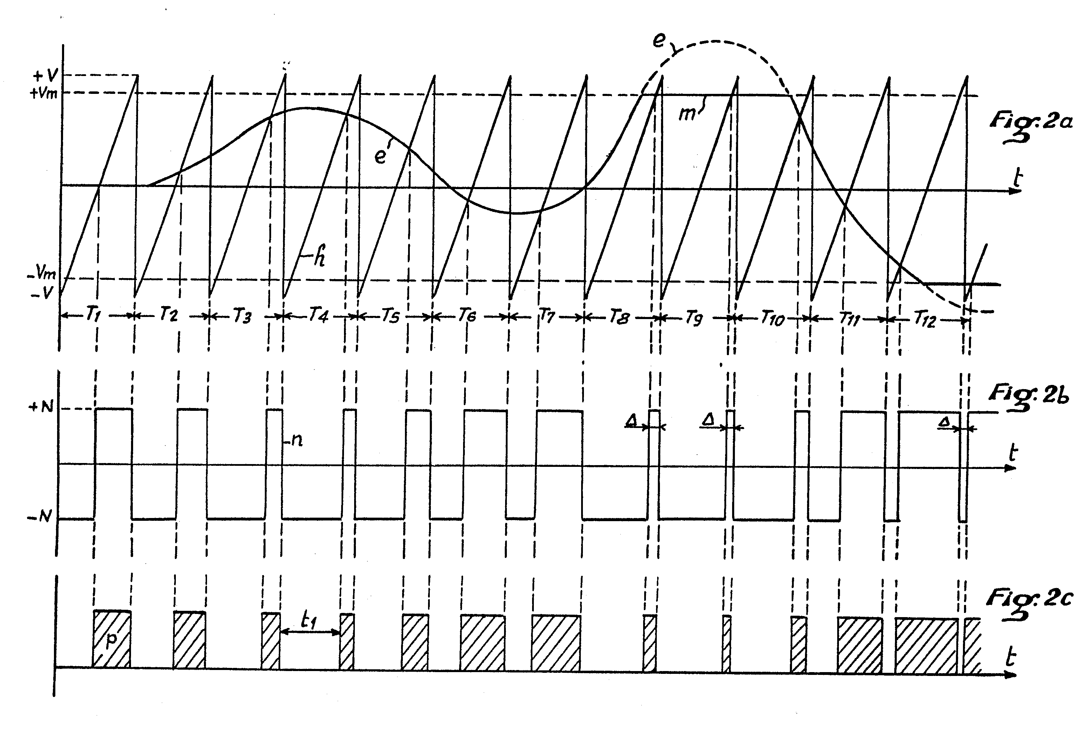

On décrira maintenant en référence aux figures 2a, 2b et 2c le fonctionnement du circuit de la figure 1 en l'absence de signal (s̄).

La figure 2a représente les variations en fonction du temps du signal de sortie (h) du générateur de rampe 2, ainsi que du signal (e) et du signal (m) de sortie du sommateur écrêteur 1. Bien entendu, comme le signal (s) est supposé nul, le signal (m) ne diffère du signal (e) que lorsque ce dernier dépasse les valeurs d'écrêtage imposées par les diodes Zener 13 et 13'. Dans ce cas, le signal (m) est constant et égal à $+V_m$ si (e) est positif et à $-V_m$ si (e) est négatif.

La figure 2b représente la variation correspondante du signal (n) de sortie du comparateur 3 et la figure 2c représente les impulsions (p) émises par le transmetteur 4.

Lorsque le signal d'entrée (e) est nul comme cela est le cas au cours de la première période $T_1$ de la rampe (h) , le comparateur 3 fournit des créneaux d'alternances négative et positive égales, le signal (n) étant égal à $-N$ lorsque (h) varie de $-V$ à 0 et étant égal à $+N$ lorsque (h) varie de 0 à $+V$.

Par contre, lorsque (e) prend des valeurs positives, comme cela est le cas pour les périodes $T_2$ à $T_5$, les créneaux positifs de (n) ont une durée inférieure à une demi-période, alors que lorsque (e) prend des valeurs négatives, comme cela est le cas pour les périodes $T_6$ et $T_7$ les créneaux positifs de (n) ont des durées supérieures à une demi-période.

On constate par conséquent que la durée des créneaux positifs de (n) varie en raison inverse de la valeur du signal (e) .

Au cours des périodes $T_8$ et $T_9$, le signal (e) dépasse la valeur $+V_m$. Il est donc écrêté à cette dernière valeur par le sommateur écrêteur 1 de sorte que, même dans ce cas, un créneau positif de largeur minimale $\Delta$ apparaît à la sortie du comparateur 3.

Les périodes $T_{10}$ et $T_{11}$ montrent de nouveau un fonctionnement normal, la période $T_{10}$ avec un signal (e) positif et la période $T_{11}$ avec un signal (e) négatif.

La période $T_{12}$ montre enfin le cas où le signal (e) devient inférieur à $-V_m$. Dans ce cas, du fait de l'écrêtage, le signal (n) devient néanmoins négatif pendant une durée minimale $\Delta$

Les impulsions (p) se déduisent immédiatement du signal (m) puisqu'elles correspondent aux créneaux positifs de ce dernier. On constate en particulier, qu'une impulsion est transmise à chaque cycle du signal (h) même si le signal (e) devient supérieur à $+V$ du fait que, dans ce cas, le signal (n) présente un créneau positif de largeur $V$ . De même, une impulsion (p) ne peut pas chevaucher deux cycles de la rampe (h) même lorsque le signal (e) devient inférieur à $-V$, puisque le signal (n) présente dans ce cas un créneau négatif de largeur $\Delta$ .

On constate par conséquent que le circuit de la figure 1 permet d'assurer la conversion d'un signal d'entrée analogique (e) en un signal de sortie par impulsions (p). A chaque cycle du générateur de fonction, la valeur du signal (e) est convertie en une durée égale au temps $t_1$ écoulé entre le début du cycle et le front avant de l'impulsion (p).

Dans le cas présent, le front arrière de l'impulsion (p) correspond au début du cycle suivant, de sorte que l'on réalise en fait une modulation de la durée des impulsions (p) par le signal (e) . Toutefois, la durée des impulsions (p) n'intervient pas au niveau de la conversion directe, et on pourrait aisément concevoir un circuit qui fournirait par exemple des impulsions de largeur constante. On verra néanmoins ci-après qu'il est utile dans certain cas de faire coincider le front arrière des impulsions avec le début du cycle suivant pour synchroniser un convertisseur inverse devant restituer un signal analogique à partir du signal par impulsions (p).

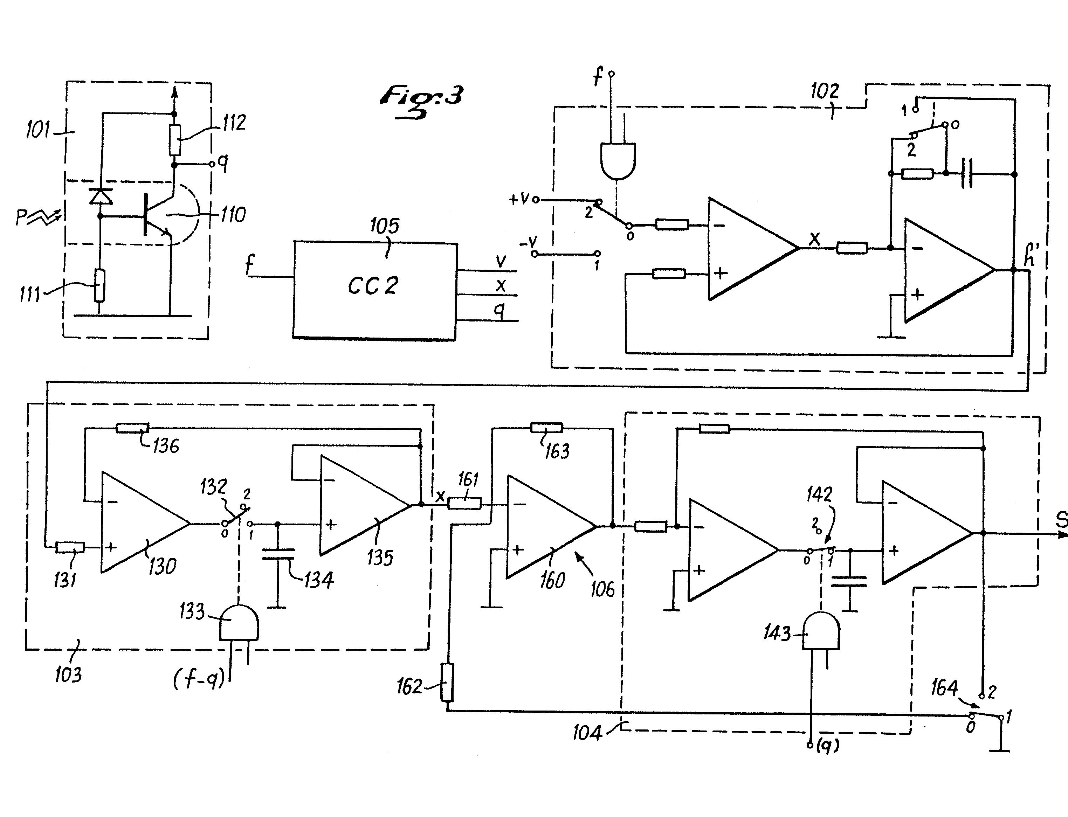

On décrira maintenant un tel convertisseur inverse en référence à la figure 3.

Ce convertisseur est essentiellement constitué par un récepteur 101, un générateur de rampe 102 fournissant le signal étalon de la conversion inverse, un échantillonneur-bloqueur de décodage 103, et un échantillonneur-bloqueur de mémorisation 104.

Dans le cas présent, le récepteur 101 est un photo-coupleur constitué de façon connue par un photo-transistor 110 dont le potentiel de base est déterminé par une résistance 111. Une deuxième résistance 112, connectée entre le collecteur du transistor 110 et l'alimentation permet de délivrer au niveau de ce collecteur un signal (q) en forme de créneaux, correspondant aux impulsions (p) et simplement décalé dans le temps par rapport à ces dernières d'une durée correspondant au temps de transmission.

Le circuit de commande 105 est similaire au circuit de commande 5 de la figure 1, à ceci près que son entrée de synchronisation reçoit le signal (q) comme signal de synchronisation à la place du signal d'horloge externe (r) . Dans le cas présent, c'est bien entendu le front arrière du signal (q) qui est utilisé pour la synchronisation comme cela a été mentionné ci-dessus.

Le générateur de fonction 102 étant identique au générateur de fonction 2 de la figure 1 ne sera pas décrit plus en détail. Son but est de former une rampe (h') qui, dans le cas présent, est identique à la rampe (h) fournie par le circuit 2.

L'échantillonneur-bloqueur de décodage 103 est composé d'un premier amplificateur 130 à grande impédance d'entrée pouvant fonctionner en inverseur ou en suiveur. La sortie (h') du générateur de rampe est appliquée à l'entrée positive de l'amplificateur 130 par l'intermédiaire d'une résistance 131.

L'amplificateur 130 est suivi par un commutateur électronique 132 piloté par une porte 133 commandée elle-même par le signal (f-q) provenant du circuit de commande 105, (f) représentant la durée d'un cycle du générateur de rampe et (q) la durée d'une impulsion.

Le commutateur 132 transmet, lorsqu'il est fermé en (0-1), la tension de sortie de l'amplificateur 130 à un condensateur 134 servant de mémoire analogique.

La tension du condensateur 134 est appliquée à l'entrée positive d'un deuxième amplificateur 135 à très grande impédance d'entrée monté en suiveur.La sortie (x) de l'amplificateur 135 est bouclée directement sur son entrée négative et par intermédiaire d'une résistance 136 à l'entrée négative de l'amplificateur 130.

Quand le commutateur 132 est fermé, l'échantillonneur-bloqueur 103 fonctionne en mode RECOPIE, c'est-à-dire que sa sortie (x) suit son entrée (h') . Dans ce mode de fonctionnement, la tension aux bornes du condensateur 134 est égale à (h') .

Si un signal (f-q) est appliquée à la porte 133, celle-ci ouvre le commutateur 132, déconnectant ainsi l'entrée (h') de la sortie (x) . Celle-ci reste alors égale à la tension aux bornes du condensateur 134 de sorte que, dans la mesure où celle-ci reste constante, la sortie (x) conserve la dernière valeur de l'entrée (h') avant l'ouverture du commutateur 132. L'échantillonneur-bloqueur 103 est alors en mode MAINTIEN.

Une nouvelle impulsion appliquée à l'entrée de la porte 133 provoque de nouveau la fermeture du commutateur 132 et le retour de l'échantillonneur-bloqueur en mode RECOPIE.

L'échantillonneur-bloqueur de mémorisation 104 est similaire à l'échantillonneur-bloqueur de décodage 103 et ne sera donc pas décrit plus en détail, si ce n'est que son commutateur 142 est piloté par une porte 143 elle même commandée par un signal (q).

On remarquera toutefois, que la sortie (x) de l'échantillonneur-bloqueur 103 est appliquée à l'entrée de l'échantillonneur-bloqueur 104 par intermédiaire d'un sommateur 106.

Le sommateur 106 est composé de façon connue d'un amplificateur 160 dont l'entrée positive est reliée à la masse et dont l'entrée négative reçoit d'une part le signal (x) par l'intermédiaire d'une résistance 161 et d'autre part le signal de sortie (s) de l'échantillonneur-bloqueur 104 par l'intermédiaire de la résistance 162. La sortie de l'amplificateur 160 est également bouclée sur son entrée négative par l'intermédiaire de la résistance 163.

Enfin, un commutateur 164 permet, lorsqu'il est en position (0-1), de fermer la boucle 162, et de l'ouvrir lorsqu'il est en position (0-2).

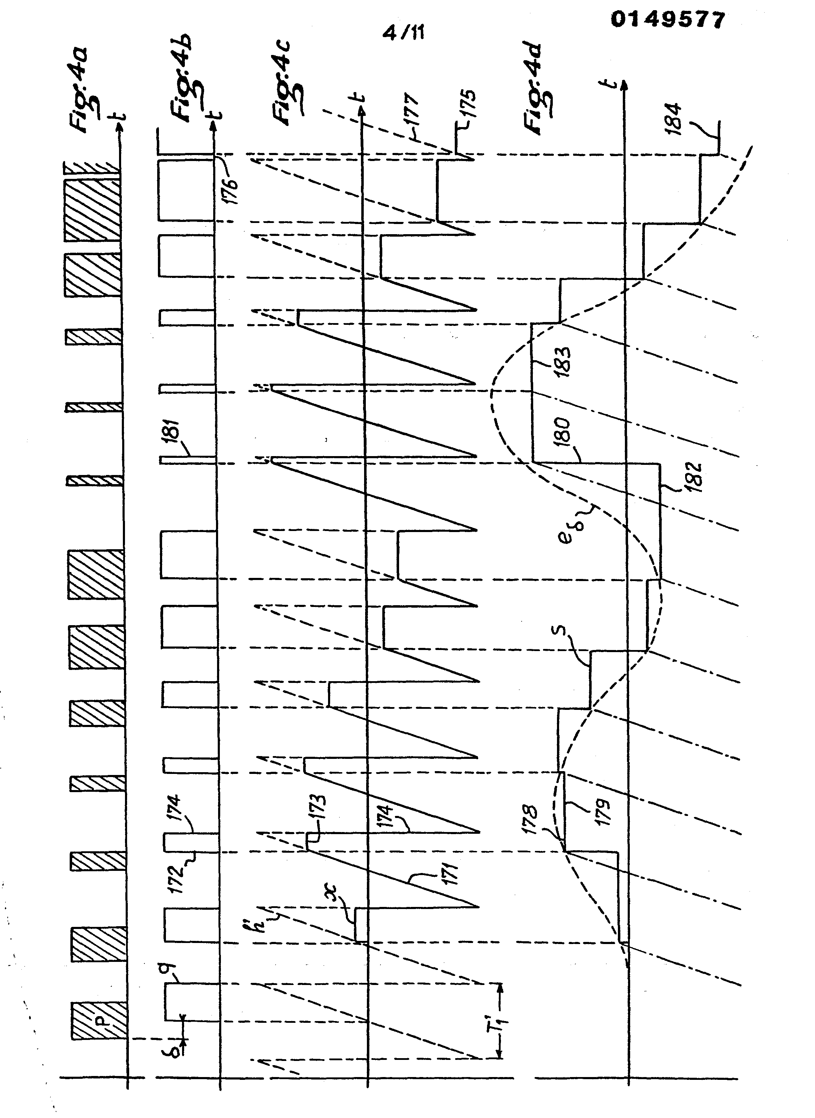

On décrira maintenant en référence aux figures 4a à 4d le fonctionnement du circuit de la figure 3.

La figure 4a reproduit les impulsions (p) de la figure 2c. La figure 4b représente les impulsions (q) à la sortie du récepteur 101, décalées des impulsions (p) de la durée de transmission $\delta$ . La figure 4c représente le signal étalon (h') et le signal de sortie (x) de l'échantillonneur-bloqueur de décodage 103. La figure 4d représente le signal de sortie (s) de l'échantillonneur-bloqueur de mémorisation 104, ainsi que, en trait interrompu un rappel $(e_\delta)$ du signal (e) qui était à l'origine des impulsions (p), décalé du temps de transmission $\delta$ .

La figure 4c illustre plus particulièrement le fonctionnement de l'échantillonneur-bloqueur de décodage 103. Le commutateur 132 étant fermé, on a vu que l'échantillonneur-bloqueur 103 est en mode RECOPIE,

- 24 -

0149577

et par conséquent que le signal (x) suit le signal (h') comme par exemple en 171.

Lorsqu'arrive le front avant 172 d'une impulsion (q) , le circuit de commande 105 envoie sur la porte 133 un signal (f-q) qui provoque le basculement de cette porte et l'ouverture du commutateur 132. L'échantillonneur-bloqueur 103 se trouve alors en mode MAINTIEN et sa sortie (x) reste constante, égale à la dernière valeur qu'elle avait avant l'ouverture du commutateur 132. Ceci est illustré par exemple en 173.

Lors du front arrière 174 de l'impulsion (q) , le circuit de commande 105 envoie sur la porte 133 une nouvelle impulsion qui provoque de nouveau son basculement et par conséquent la fermeture du commutateur 132 et la remise de l'échantillonneur-bloqueur 103 en mode RECOPIE. Le signal (x) suit de nouveau le signal (h') comme en 174.

On constate tout d'abord, sur le premier cycle $T_1'$ du signal (h') , qu'un signal (q) ayant des alternances égales (on rappelle que ceci traduit un signal d'entrée (e) nul) se traduit par un signal (x) nul.

Par ailleurs, on remarque en 175 l'utilité du marqueur négatif décrit ci-dessus. En effet, à défaut de ce marqueur, le signal (q) ne reviendrait pas à 0 comme en 176, aucun front avant ne serait détecté par le circuit de commande 105, et par conséquent le signal (x) continuerait à suivre le signal (h') en 177. Le marqueur négatif permet donc le recalage de l'échantillonneur-bloqueur 103 dans le cas où le signal d'entrée (e) deviendrait inférieur à la valeur minimale de la rampe (h) . La différence entre cette valeur minimale -V et la valeur d'écrêtage $-V_m$ est choisie de manière que l'échantillonneur-bloqueur 103 ait le temps de se recaler en mode MAINTIEN.

L'échantillonneur-bloqueur 104 est commandé par le circuit 105 par un signal (q) de telle sorte qu'il soit en mode MAINTIEN lorsque

0149577

l'échantillonneur-bloqueur 103 est en mode RECOPIE et qu'il soit en mode RECOPIE lorsque l'échantilloneur-bloqueur 103 est en mode MAINTIEN.

Par conséquent, lors du front avant 172 d'une impulsion (q) , l'échantillonneur-bloqueur 104 se positionne en mode RECOPIE, de sorte que sa sortie (s) suit la sortie (x) de l'échantillonneur-bloqueur 103 comme en 178. Lors du front arrière 174 de l'impulsion (q) , l'échantillonneur-bloqueur 104 se positionne en mode MAINTIEN de sorte que sa sortie (s) conserve en 179 la valeur qu'elle avait en 178.

L'échantillonneur-bloqueur 104 assure donc la mémorisation du signal décodé (x) jusqu'à l'arrivée de l'impulsion suivante.

On remarque en 180 l'utilité du marqueur positif décrit ci-dessus. En effet, à défaut de ce marqueur, l'impulsion (q) 181 n'existerait pas de sorte que la sortie (s) de l'échantillonneur-bloqueur 104 conserverait la valeur qu'elle avait en 182 au cours du cycle précédent.

On constate sur la figure 4d que le circuit de la figure 3 génère un signal (s) qui n'est autre que le signal d'entrée (e) dans le circuit de la figure 1, décalé dans le temps de la durée de transmission $\delta$ , écrêté comme en 183 ou 184, et échantillonné.

On notera toutefois, que cet échantillonnage est distinct de l'échantillonnage classique. En effet, une valeur d'échantillonnage est bien produite à chaque cycle des rampes (h) et (h') mais l'échantillonnage n'est pas périodique pour autant. En effet, l'instant auquel il se produit dépend de la valeur du signal d'entrée (e) .

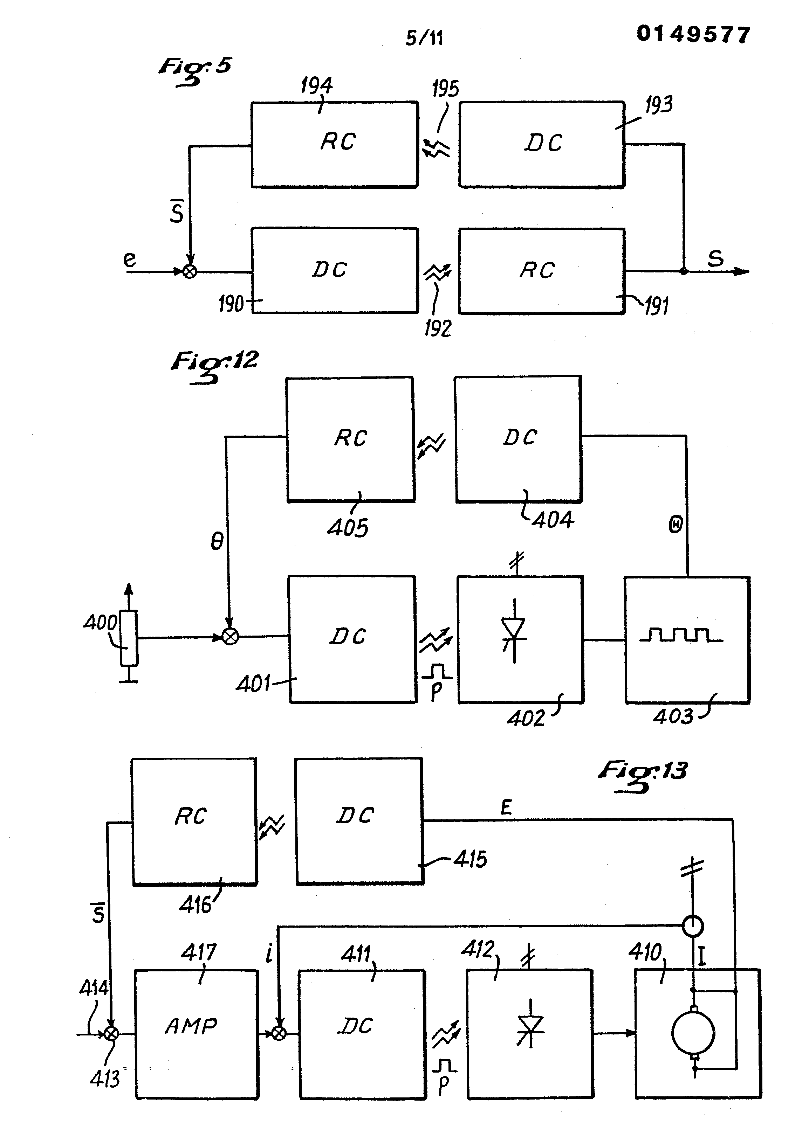

La figure 5 représente un schéma permettant de faire fonctionner les dispositifs des figures 1 et 3 en boucle fermée.

- 26 -

Ce schéma comporte dans sa boucle directe un circuit 190 tel que celui de la figure 1 et un circuit 191 tel que celui de la figure 3. Ces deux circuits sont couplés en 192 par tous moyens convenables, par exemple par des moyens optiques tels que ceux décrits précédemment.

La boucle retour comporte également un circuit 193 tel que celui de la figure 1 et un circuit 194 tel que celui de la figure 3, couplés en 195.

Dans cet agencement, le signal (s) inversé est transmis par la boucle de retour 193, 194 pour être réinjecté à l'entrée 11 du circuit 190. Par conséquent, la boucle directe ne transmet que la différence entre le signal d'entrée (e) et le signal de sortie (s) . Pour cette raison, le commutateur 164 du circuit 191 est positionné en (0-1) de manière à additionner sur le sommateur 106 le signal (x) représentatif du signal de différence et le signal de sortie (s) .

Bien entendu, dans ce cas, l'entrée 11 du circuit 193 n'est pas utilisée et le commutateur 164 du circuit 194 est dans sa position (0-2). En effet, la boucle de retour a pour seul but de retransmettre le plus rapidement possible la tension de sortie (s) à l'entrée 11 du circuit 190.

On peut noter ici un des avantages essentiels de l'invention. On vient en effet de montrer comment le dispositif peut fonctionner en boucle fermée avec les circuits 190 et 191 dans la boucle directe entre l'entrée (e) et la sortie (s) , et les circuits 193 et 194 dans la boucle de retour entre la sortie (s) et l'entrée (e) . Il suffit, pour fonctionner en boucle fermée en sens inverse, d'ouvrir le commutateur 164 du circuit 191 et de fermer celui du circuit 194, de déconnecter l'entrée 11 du circuit 190, et de relier la sortie du circuit 191 à l'entrée 11 du circuit 193.

Il est également possible de fonctionner en deux boucles ouvertes, en déconnectant les entrées 11 des deux circuits 190 et 193 et en ouvrant les commutateurs 164 des circuits 191 et 194.

Un autre avantage du schéma de la figure 5 est d'avoir une régulation avec gain proportionnel. En effet, dès que le premier cycle est transmis, on obtient immédiatement en sortie la valeur correspondant au signal d'entrée. Avec un retard égal à 2 $\delta$ ,le signal (s) revient en opposition sur l'entrée 11 du circuit 190.

Dès le deuxième cycle, la régulation transmet donc l'écart (e-s) ou (e+s) de sorte que, cet écart étant faible, le signal direct transmis est centré autour du OV du générateur de fonction, valeur pour laquelle la précision du système est la plus grande.

On est ainsi assuré qu'en boucle fermée le système fonctionne à son niveau de précision maximal.

Par ailleurs, ce schéma se prête aisément au multiplexage des signaux analogiques.

Le multiplexage se fait directement sur les signaux d'entrée en 10 et 11 des circuits 190 et 193, et le démultiplexage s'effectue en débouclant les échantillonneurs-bloqueurs 103 et 104 des circuits 191 et 194 au niveau des entrées 161 et 162 des sommateurs 160.

Par ailleurs, un autre avantage important de l'agencement de la figure 5 utilisé en tant que système d'acquisition de données conjointement avec un multiplexage de signaux, résulte du fait que l'horloge du système de multiplexage peut être utilisée pour la synchronisation des générateurs de fonction des convertisseurs direct et inverse. Par exemple, à l'aide d'un système de multiplexage à seize voies, on peut transmettre quinze signaux, la seizième voie servant à l'impulsion de synchronisation.

On n'a considéré jusqu'à présent que des signaux étalons linéaires fournis par les générateurs de rampe 2 et 102 des convertisseurs direct et inverse respectivement. On montrera maintenant que toute autre forme d'étalon peut être envisagée.

- 28 -

Tout d'abord, si les deux étalons de la conversion directe et de la conversion inverse sont identiques, il va de soi que le signal de sortie (s) sera identique au signal d'entrée (e) quelque soit la forme de ces étalons aux déformations près mentionnées ci-dessus en référence à la figure 4d :retard, écrêtage et échantillonnage. Toutefois, si la durée de transmission est négligeable, si le signal d'entrée ne dépasse pas les valeurs minimale et maximale admissibles, et si la fréquence des générateurs de fonction est grande par rapport à la vitesse d'évolution du signal d'entrée, on peut considérer que les signaux d'entrée et de sortie sont identiques.

Par ailleurs, il est aisé de constater que, si les signaux étalon de la conversion directe et de la conversion inverse sont différents, le signal de sortie prend la valeur du signal étalon de la conversion inverse à chaque fois que la valeur du signal étalon de la conversion directe atteint la valeur du signal d'entrée.

Ces deux observations permettent de tracer simplement par simple relèvement des temps, le signal de sortie (s) à partir du signal d'entrée (e) et des signaux étalons.

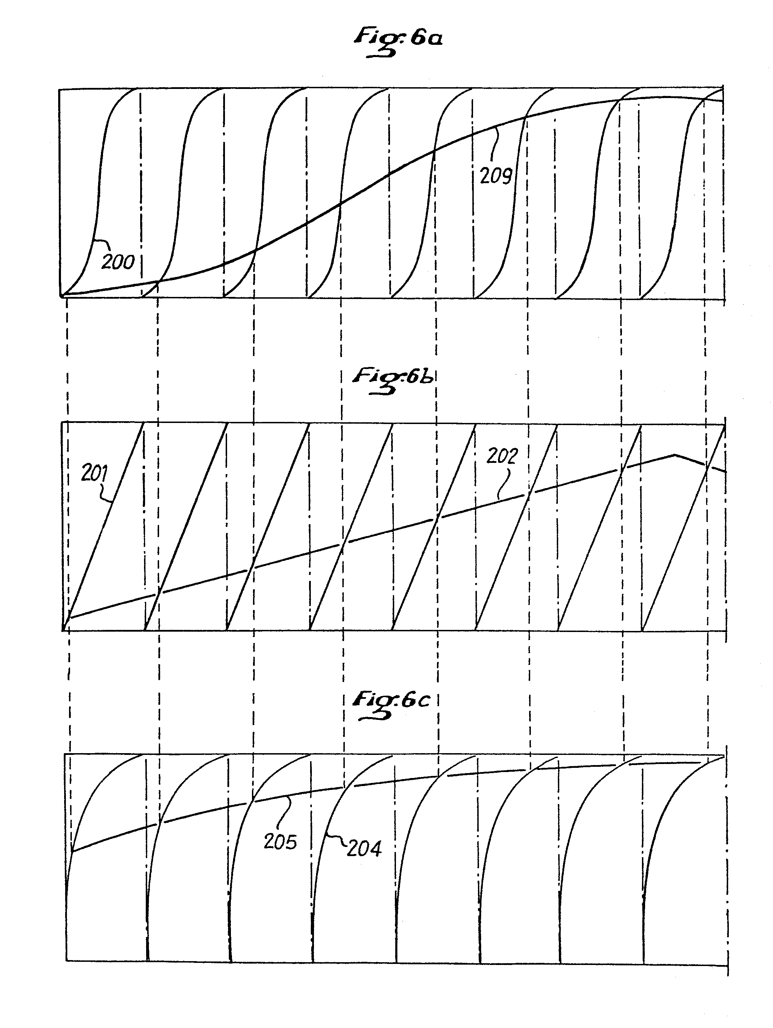

On observera maintenant sur les figures 6a à 6c le résultat de l'utilisation de divers étalons, tant pour la conversion directe que pour la conversion inverse.

Les figures 6a et 6b, prises en combinaison dans cet ordre, illustrent le cas où le signal étalon de la conversion directe est une demi-sinusoïde 200 et où le signal étalon de la conversion inverse est une rampe 201. On a vu que le signal de sortie 202 pouvait être tracé à partir du signal d'entrée 203 par relèvement des temps comme cela est effectué sur les figures.

On constate que si le signal d'entrée 203 est une demi-sinusoïde de fréquence faible par rapport à celle de l'étalon, le signal de sortie 202 est une droite.

Les figures 6a et 6b étant parfaitement réversibles, il est évident que, si l'on utilise comme étalon de conversion directe la rampe 201, et comme étalon de conversion inverse la demi-sinusoïde 200, on obtiendra un signal de sortie 203 sous forme d'une demi-sinusoïde à partir d'une rampe 202 en signal d'entrée.

On voit comment les dispositifs selon l'invention permettent de réaliser des transformations de courbes. Dans l'exemple des figures 6a et 6b, il est ainsi possible d'obtenir des sinusoïdes de très faible fréquence à partir de rampes qui sont faciles à réaliser.

La combinaison des figures 6a et 6c dans cet ordre illustre le cas où le signal étalon du convertisseur direct et d'une exponentielle 204 et où le signal étalon du convertisseur inverse est une rampe 201. Dans le cas où le signal d'entrée est également une exponentielle 205, on constate que le signal de sortie 202 est une rampe.

On voit ainsi comment il est possible de linéariser un capteur ayant une caractéristique exponentielle.

Les différentes combinaisons possibles des figures 6a à 6c, montrent encore comment il est possible de transformer une sinusoïde en exponentielle ou inversement, ou d'obtenir une exponentielle à partir d'un rampe.

Bien entendu, cette conversion de courbes peut être appliquée à toutes courbes ou combinaisons de courbes particulières.

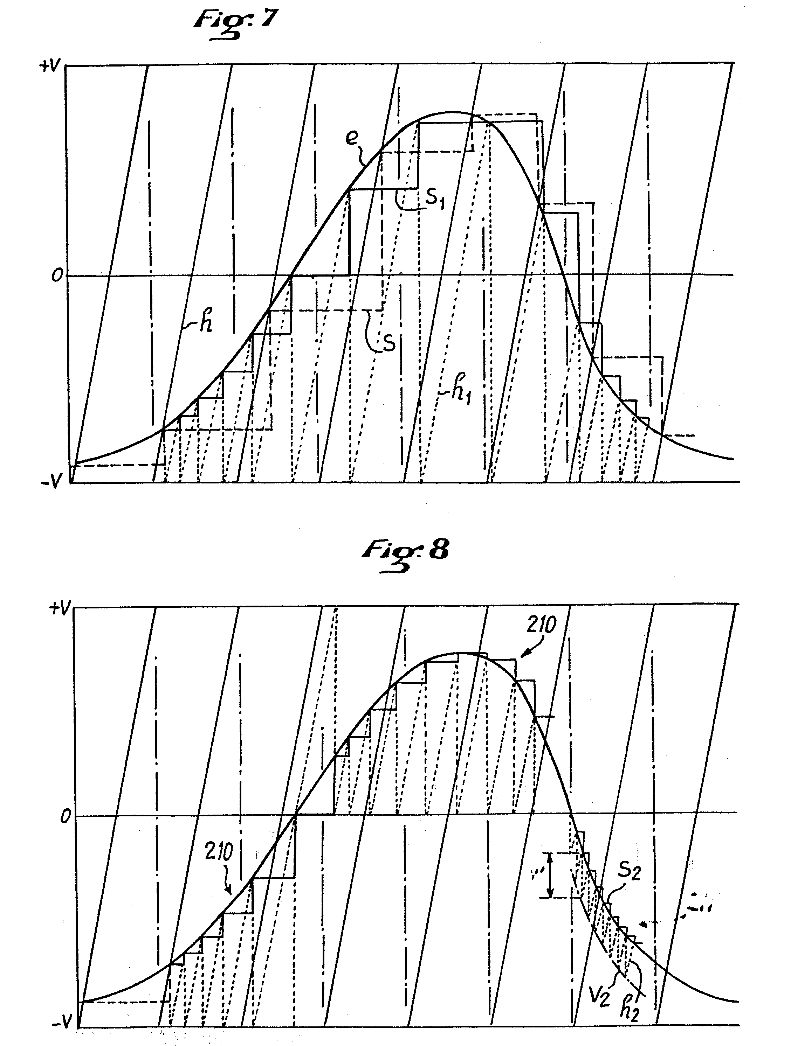

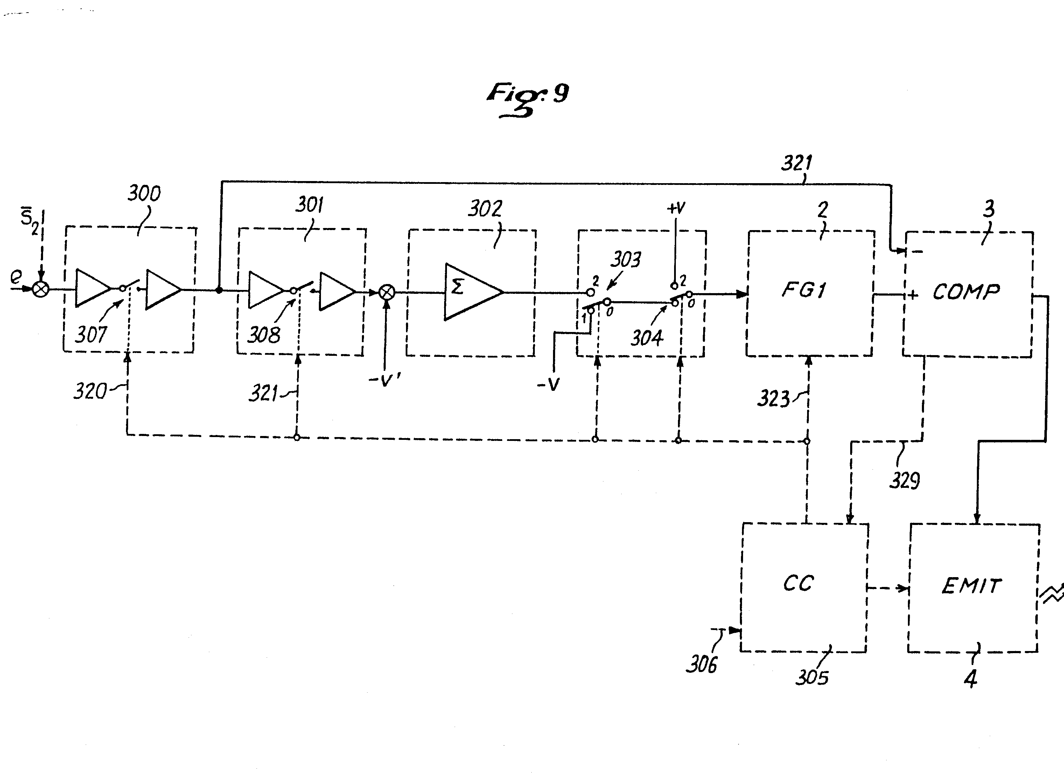

Les figures 7 et 8 représentent graphiquement les résultats obtenus à l'aide d'autres formes de réalisation de l'invention résultant de modifications des dispositifs représentés aux figures 1 et 3.

La figure 7 montre qu'il est possible d'améliorer le signal de sortie (s) , du moins pour les valeurs négatives du signal d'entrée (e), en recommençant un nouveau cycle du signal étalon dès que la valeur de celui-ci a atteint la valeur du signal d'entrée. Alors que le signal étalon (h) décrit précédemment ne revenait à la valeur -V qu'après avoir atteint la valeur +V, le signal $(h_1)$ considéré maintenant revient à la valeur -V dès qu'il a atteint la valeur du signal d'entrée (e).

Il suffit pour cela de commander, par l'intermédiaire du circuit 5, les commutateurs 22 et 27 du générateur de rampe 2 de manière qu'ils basculent immédiatement après le comparateur 3. Le décalage entre le basculement du comparateur 3 et celui des commutateurs 22 et 27 est déterminé de façon à obtenir une impulsion (p) de largeur juste suffisante pour permettre à l'échantillonneur-bloqueur 104 du convertisseur inverse d'atteindre, en mode RECOPIE, la valeur de sortie de l'échantillonneur-bloqueur 103.

On constate alors sur la figure 7 que le signal de sortie $(s_1)$ suit de plus près le signal d'entrée (e) que le signal de sortie (s) et que ceci est particulièrement net lorque le signal (e) est négatif.

La figure 8 montre dans ses parties 211 qu'il est possible d'obtenir le même avantage quelque soit le signe du signal d'entrée (e).

Il suffit pour cela de disposer de deux générateurs de rampe (h), l'un positif et l'autre négatif. On obtient alors deux impulsions correspondant chacune à un signe du signal d'entrée. Il faut alors deux circuits émetteurs et donc deux dispositifs de décodage dans le convertisseur inverse mais un seul circuit de mémorisation 104 suffit.

La figure 8 montre également dans sa partie 210 qu'il est possible de grandement améliorer le signal de sortie $(s_2)$ en utilisant comme valeur de référence pour le signal étalon $(h_2)$, à la place de la valeur fixe -V, une valeur $V_2$ déduite de la valeur échantillonnée précédente. Dans le cas de la figure 8, cette valeur $V_2$ est égale à la valeur échantillonnée précédente diminuée d'une tension V' déterminée.

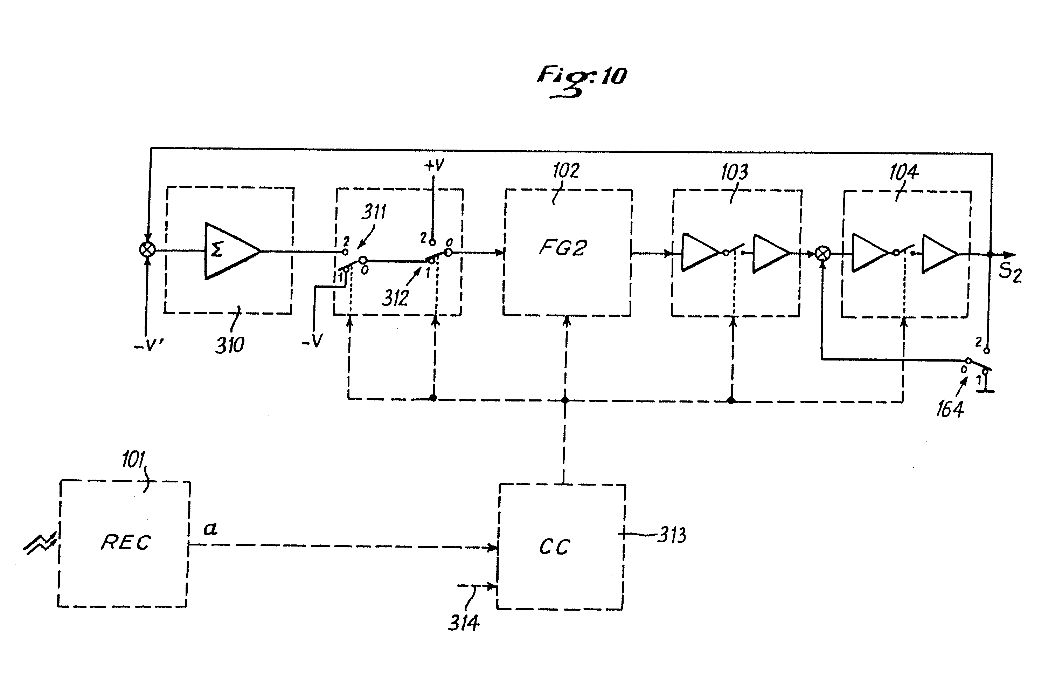

Ceci peut être obtenu à l'aide des dispositifs auto-adaptatifs représenté aux figures 9 et 10 que l'on décrira maintenant.

Les mêmes références seront affectées aux circuits communs aux figures 9 et 10 d'une part, et 1 et 3 d'autre part.

Le signal (e) en boucle ouverte, ou $(e+\bar{s}_2)$ en boucle fermée, est appliqué à l'entrée d'un échantillonneur-bloqueur 300 dont la sortie est appliquée d'une part à l'entrée négative du comparateur 3 et d'autre part à l'entrée d'un échantillonneur-bloqueur 301.

La tension -V' est additionnée à la tension de sortie de l'échantillonneur-bloqueur 301 dans un sommateur 302.

Un commutateur 303 a sa sortie reliée soit à la tension -V en position (0-1) soit à la sortie du sommateur 302 en position (0-2). Un autre commutateur 304 a sa sortie reliée soit à la sortie du commutateur 303 en position (0-1), soit à la tension +V en position (0-2).

La sortie du commutateur 304 est appliquée à l'entrée du générateur de fonction 2 dont la sortie est reliée à l'entrée positive du comparateur 3. La sortie de ce comparateur est appliquée comme précédemment à l'entrée de l'émetteur 4.

Un circuit de commande 305 recevant d'une part la sortie du comparateur 3 et d'autre part des impulsions de remise à zéro 306 pilote les commutateurs 307 et 308 des échantillonneurs-bloqueurs 300 et 301 respectivement, ainsi que les commutateurs 303 et 304.

La figure 10 représente le convertisseur inverse du dispositif auto-adaptatif.

Un sommateur 310 additionne la tension -V' à la sortie $(s_2)$ du convertisseur inverse de manière à former la valeur de référence du générateur de fonction 102.

Un commutateur 311 a sa sortie reliée soit à la tension -V, soit à la sortie du sommateur 310, et un commutateur 312 a sa sortie reliée soit à cette sortie du commutateur 311, soit à la tension +V.

La sortie du commutateur 312 est appliquée à l'entrée du générateur de fonction 102.

Un circuit de commande 313 recevant d'une part les impulsions (q) issues du récepteur 101, et d'autre part un signal de remise à zéro 314, pilote les commutateurs 311 et 312, les commutateurs du générateur de fonction 102, ainsi que les commutateurs des échantillonneurs-bloqueurs 103 et 104.

Dans le circuit de la figure 9, l'échantillonneur-bloqueur 300 assure la mémorisation de la valeur du signal d'entrée à l'instant où cette valeur est atteinte par la valeur du signal étalon. A cet effet, le commutateur 307 est commandé par un signal 320 de telle sorte que l'échantillonneur-bloqueur 300 soit en mode RECOPIE au début du cycle du signal étalon, puis qu'il se positionne en mode MAINTIEN lorsque le comparateur 3 a détecté l'égalité du signal d'entrée et du signal étalon.

L'échantillonneur-bloqueur 301 est commandé par le circuit 305 par l'intermédiaire d'un signal 321 de sorte qu'il soit en mode MAINTIEN lorsque l'échantillonneur-bloqueur 300 est en mode RECOPIE et inversément. Le fonctionnement combiné des échantillonneurs-bloqueurs 300 et 301 est identique à ce qui a été décrit ci-dessus en référence aux échantillonneurs-bloqueurs 103 et 104.

La tension -V' est ajoutée à la tension de sortie de l'échantillonneur-bloqueur 301 dans le sommateur 302 et, en fonctionnement normal, le commutateur 303 est en position (0-2) et le commutateur 304 en position (0-1). On comprend que, de la sorte, la tension de référence fournie à l'entrée du générateur de fonction 102 est la tension d'entrée diminuée de la tension V'.

De même, dans le convertisseur inverse de la figure 10, le commutateur 311 est, en fonctionnement normal, en position (0-2), et le commutateur 312 en position (0-1). Ainsi, la tension de référence fournie à l'entrée du générateur de fonction 102 est égale à la tension de sortie ($s_2$) diminuée de la tension V'.

La figure 11 représente le fonctionnement combiné en boucle ouverte des circuits des figures 9 et 10.

Au départ, les commutateurs 303 et 311 sont en position (0-1) et les commutateurs 304 et 312 sont en position (0-2). Ainsi, le générateur de fonction 2 génère une demi-rampe complète 320 provoquant l'émission d'une impulsion codée 0 lorsqu'elle atteint 0 volt de tension. Cette impulsion 0 assure par son front arrière le démarrage du générateur de fonction 102 du convertisseur inverse. Le front arrière de l'impulsion 1 provoque ensuite le basculement des commutateurs 303, 304 , 311 et 312 de sorte que le système se trouve en mode auto-adaptatif, puisque la valeur de référence du générateur de rampe est maintenant égale à la valeur de l'échantillonnage précédent diminué de V' volts.

Le commutateur 307 de l'échantillonneur-bloqueur 300 est également fermé à cet instant de sorte que cet échantillonneur-bloqueur fonctionne en mode RECOPIE, et la tension d'entrée est transmise au comparateur 3 par intermédiaire de la ligne 321. Lorsque la tension 322 à la sortie du générateur de fonction 2 atteint la valeur du signal de sortie de l'échantillonneur-bloqueur 300, le comparateur 3 change d'état et ce changement d'état est détecté par le circuit 305 par l'intermédiaire de la ligne 323.

Le circuit 305 émet alors des signaux 320 et 321 qui provoquent le passage de l'échantillonneur-bloqueur 300 en mode MAINTIEN et le passage de l'échantillonneur-bloqueur 301 en mode RECOPIE.

La rampe étalon se poursuit jusqu'à ce que le circuit de commande 305 émette un signal 323 provoquant l'initialisation d'un nouveau cycle du générateur de fonction 2.

Simultanément, l'échantillonneur-bloqueur 300 repasse en mode RECOPIE tandis que l'échantillonneur-bloqueur 301 repasse en mode MAINTIEN.

Le convertisseur inverse de la figure 10 fonctionne de manière similaire à celui de la figure 3, à ceci près que le sommateur 310 fournit comme valeur de référence la valeur du signal de sortie ($s_2$) diminué de la tension V'.

Comme dans le convertisseur direct de la figure 9, les commutateurs 311 et 312, qui sont à l'origine reliés aux tensions -V et +V respectivement, passent en mode auto-adaptatif à la suite de l'impulsion O.

On observera en outre que, chaque fois qu'un certain nombre donné de cycles ont été effectués en mode auto-adaptatif, un cycle peut être effectué avec un demi étalon afin de recaler le convertisseur inverse sur le convertisseur direct.

En boucle fermée, le commutateur 164 du convertisseur inverse sera placé en position (0-2) par le circuit de commande 313 à la fin de l'impulsion O.

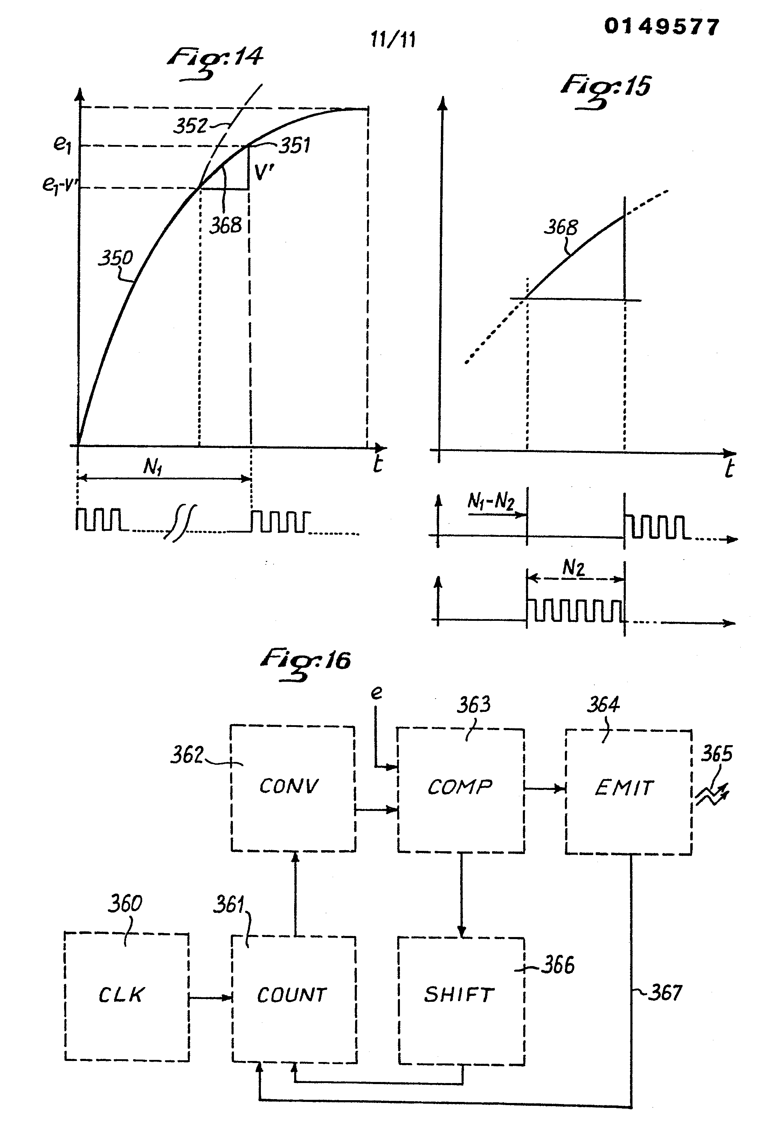

La figure 14 illustre la difficulté que l'on rencontre lorsque l'on souhaite utiliser le mode auto-adaptatif avec un étalon non linéaire 350.

Si l'égalité entre cet étalon et le signal à convertir est détectée en 351 pour une valeur $e_1$ de la tension, il demeure possible de soustraire de cette tension $e_1$ la tension V' pour en déduire la nouvelle valeur de référence $e_1$-V'.

Toutefois, si le signal étalon 350 est obtenu par des voies analogiques, il n'est généralement pas possible de faire repartir ce signal étalon de la valeur $e_1$-V'. On obtiendra donc au deuxième cycle un signal étalon 352 se distinguant d'une manière inacceptable du signal 350.

Le schéma de la figure 16 représente un dispositif permettant de résoudre ce problème par des moyens numériques.

Ce dispositif comprend une horloge 360 dont les impulsions sont comptées dans un compteur 361. Un dispositif de conversion 362 est agencé pour déduire pour chaque valeur du compteur 361, c'est-à-dire pour chaque instant t, la valeur du signal étalon 350. La comparaison avec le signal d'entrée (e) est effectuée comme précédemment dans un comparateur 363 relié à un émetteur 364 qui émet un signal 365 lorsque le comparateur 363 détecte l'égalité entre le signal (e) et le signal issu du dispositif de conversion 362.

Cette égalité ayant été détectée après un nombre $N_1$ de signaux d'horloge (figure 14), on provoque en 366 un décalage du compteur 361 correspondant à $N_2$ signaux d'horloge vers l'arrière (figure 15). Ce décalage est effectué lorsque l'émetteur 364 envoie au compteur un signal de validation 367 indiquant la fin de l'émission du signal 365.

La figure 15 montre que le compteur 361 recommence à compter à partir de $N_1 - N_2$ et que le dispositif de conversion 362 génère alors la partie correspondante 368 du signal étalon 350.

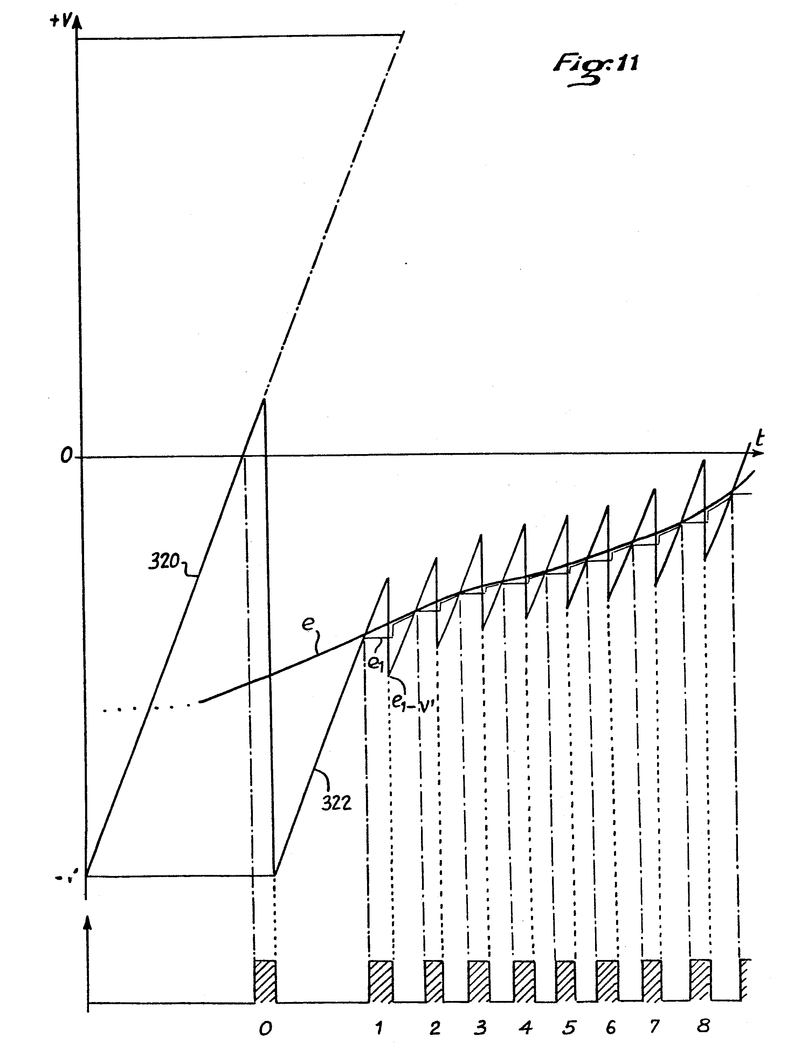

Les figures 12 et 13 illustrent deux applications particulières de l'invention.

La figure 12 représente un régulateur de température dans lequel la valeur de consigne est donnée par un potentiomètre 400. Cette valeur de consigne, diminuée du signal de retour θ , est appliquée à l'entrée d'un convertisseur direct 401, par exemple tel que décrit en référence à la figure 1.

Les impulsions (p) émises par le convertisseur 401 sont directement utilisées pour la commande de thyristors 402 qui alimentent des résistances 403.

Sur ces résistances, un capteur détecte la température θ qui est transmise par une boucle de retour constituée par un convertisseur direct 404 et un convertisseur inverse 405 tel que décrits par exemple en référence aux figures 1 et 3 respectivement.

La figure 13 représente un régulateur à deux boucles, faisant également application de l'invention.Il s'agit d'un régulateur de vitesse pour un moteur à courant continu 410 alimenté par un réseau alternatif monophasé.

Une boucle interne de courant est constituée par un convertisseur direct 411 engendrant des impulsions (p) utilisées comme précédemment pour la commande de thyristors 412 alimentant le moteur 410.

La boucle externe est la boucle de vitesse. Le sommateur 413 reçoit la valeur de consigne 414 ainsi que la valeur actuelle de la vitesse, transmise par la boucle de retour constituée par un convertisseur direct 415 et un convertisseur inverse 416 tel que décrits par exemple en référence aux figures 1 et 3.

La sortie du sommateur 413 est appliquée à un amplificateur 417, dont la sortie est additionnée dans un sommateur 418 à la valeur transmise par la boucle de retour interne.

Avantageusement, la mesure de la vitesse transmise par le convertisseur 415 est constituée par la force contre-électromotrice aux bornes du moteur 410, mesurée en dehors des périodes où ce moteur est alimenté par les thyristors 412.

Bien entendu, diverses variantes et modifications peuvent être apportées aux dispositifs décrits ci-dessus sans sortir pour autant du cadre ni de l'esprit de l'invention.

RECAPITULATIF DES SYMBOLES

a : signal de commande du générateur de rampe (2) du convertisseur direct

e : signal analogique d'entrée sur le convertisseur direct

f : signal de commande du générateur de rampe (102) du convertisseur inverse

m : sortie du sommateur d'entrée (1) du convertisseur direct

0149577

n : sortie du comparateur (3) du convertisseur direct

p : impulsion émise par l'émetteur (4) du convertisseur direct

q : impulsion émise par le récepteur (101) du convertisseur inverse

v : signal de validation du circuit de commande (5)

s : signal de sortie du convertisseur inverse

$\bar{s}$ : signal inverse de s

u : signal de sortie du comparateur du générateur de rampe (2) du convertisseur direct

V : tension de référence des générateurs de rampe (2) et (102)

x : signal de sortie de l'échantillonneur-bloqueur de décodage (103)

REVENDICATIONS

1. Procédé de conversion d'un signal analogique (e) en un signal par impulsions (p), caractérisé par le fait que l'on commence à générer, à des instants déterminés, un premier signal étalon (h) variant à partir d'une valeur de référence, que l'on compare, à partir desdits instants, le signal analogique au signal étalon, et que l'on émet une impulsion (p) lorsque la valeur du signal étalon atteint la valeur du signal analogique.

2. Procédé selon la revendication 1, caractérisé par le fait que ladite impulsion est prolongée jusqu'à l'instant déterminé auquel on commence à générer le signal étalon suivant.

3. Procédé selon l'une quelconque des revendications, 1 et 2, caractérisé par le fait que ledit signal étalon est un signal périodique, lesdits instants déterminés étant séparés d'une durée égale à la période du signal étalon.

4. Procédé selon l'une quelconque des revendications 1 et 2, caractérisé par le fait que lesdits instants déterminés sont les instants où le signal a atteint la valeur du signal analogique lors de la comparaison précédente.

5. Procédé pour la conversion d'un signal par impulsions (p) obtenu par le procédé selon l'une quelconque des revendications 1 à 4, en un signal analogique (s), caractérisé par le fait que l'on commence à générer, à des instants synchronisés sur ledit signal par impulsions, un deuxième signal étalon (h') variant à partir d'une deuxième valeur de référence, que l'on relève la valeur de ce deuxième signal étalon au moment de la réception de ladite impulsion (p), et que l'on mémorise cette valeur jusqu'à la réception de l'impulsion suivante.

6. Procédé selon la revendication 5, caractérisé par le fait que ledit deuxième signal étalon est sensiblement identique au premier signal étalon.

- 39 -

0149577

7. Procédé selon la revendication 5, caractérisé par le fait que le deuxième signal étalon a une valeur de référence et/ou une fréquence différente de celle du premier signal étalon.

8. Procédé selon l'une quelconque des revendications 5 à 7, caractérisé par le fait que ledit deuxième signal étalon est synchronisé sur le premier signal étalon par les fronts arrière des impulsions.

9. Procédé selon l'une quelconque des revendications 1 à 8, caractérisé par le fait que ladite valeur de référence est une valeur fixe (-V).

10. Procédé selon la revendication 9, caractérisé par le fait que ladite valeur fixe est modulée.

11. Procédé selon l'une quelconque des revendications 1 à 8, caractérisé par le fait que ladite valeur de référence est déduite de la valeur qu'avait le signal analogique lorsque cette dernière a été atteinte par la valeur du signal étalon lors de la comparaison précédente.

12. Procédé selon la revendication 11, caractérisé par le fait que ladite valeur de référence est égale à ladite valeur qu'avait le signal analogique à laquelle est ajoutée algébriquement une quantité prédéterminée (-V').

13. Procédé selon l'une quelconque des revendications 1 à 12, caractérisé par le fait que ledit signal étalon est une rampe.

14. Procédé selon l'une quelconque des revendications 1 à 13, caractérisé par le fait que, pour générer lesdits signaux étalons, on compte des signaux d'horloge dans un compteur, et que l'on convertit à chaque signal d'horloge le contenu du compteur en un signal analogique.

15. Procédé selon l'ensemble des revendications 12 et 14, caractérisé par le fait que, pour ajouter algébriquement ladite quantité prédéterminée, on provoque un décalage du compteur.

16. Dispositif de conversion par la mise en oeuvre du procédé selon l'une quelconque des revendications 1 à 4, caractérisé par le fait qu'il comprend un générateur de fonction (1) pour générer le signal étalon, un comparateur (3) pour comparer ledit signal analogique au signal étalon, et un émetteur (4) pour émettre une impulsion lorsque le comparateur détecte l'égalité du signal analogique et du signal étalon.

17. Dispositif selon la revendication 16, caractérisé par le fait que ledit générateur de fonction est un générateur de rampe à front raide.

18. Dispositif selon la revendication 17, caractérisé par le fait que le générateur de fonction est agencé pour que les valeurs d'extrémité (-V, +V) de la rampe soient supérieures, en valeur absolue, à la valeur maximale ($-V_m$, $+V_m$) dudit signal analogique.

19. Dispositif selon l'une quelconque des revendications 16 à 18, caractérisé par le fait que le comparateur est agencé pour fournir des impulsions dont le front avant correspond à la détection de l'égalité entre le signal analogique et le signal étalon, et dont le front arrière correspond auxdits instants déterminés auxquels on commence à générer le signal étalon suivant.

20. Dispositif selon l'une quelconque des revendications 16 à 19, pour la mise en oeuvre du procédé selon la revendication 11, caractérisé par le fait qu'il comprend un premier échantillonneur-bloqueur (300) à l'entrée duquel est appliqué ledit signal analogique, un deuxième échantillonneur-bloqueur (301) à l'entrée duquel est appliquée la sortie du premier échantillonneur-bloqueur, des moyens (305) pour faire passer le premier échantillonneur-bloqueur en mode MAINTIEN et le deuxième échantillonneur-bloqueur en mode RECOPIE lors de la détection par le comparateur de l'égalité entre le signal analogique et le signal étalon, et pour faire repasser le premier échantillonneur-bloqueur en mode RECOPIE et le deuxième échantillonneur-bloqueur en mode MAINTIEN auxdits instants déterminés auxquels on commence à générer le signal étalon suivant, et des moyens (302) pour déduire de la sortie du deuxième échantillonneur-bloqueur ladite valeur de référence du signal étalon.

21. Dispositif selon la revendication 20, caractérisé par le fait que lesdits moyens pour déduire de la sortie du deuxième échantillonneur-bloqueur ladite valeur de référence comprennent un sommateur pour ajouter algébriquement une quantité prédéterminée à ladite sortie.

22. Dispositif selon l'une quelconque des revendications 20 et 21, caractérisé par le fait que l'entrée du comparateur correspondant au signal analogique est reliée à la sortie dudit premier échantillonneur-bloqueur.

23. Dispositif de conversion pour la mise en oeuvre du procédé selon l'une quelconque des revendications 5 à 8, caractérisé par le fait qu'il comprend un récepteur (101) pour la réception des impulsions du signal par impulsions, un deuxième générateur de fonction (102) pour générer le deuxième signal étalon, des moyens (105) pour synchroniser ledit deuxième signal étalon sur le premier signal étalon, et des moyens (103, 102) pour mémoriser la valeur atteinte par le deuxième signal étalon lors de la réception d'une impulsion.

24. Dispositif selon la revendication 23, caractérisé par le fait que les moyens pour mémoriser la valeur du deuxième signal étalon comprennent un troisième échantillonneur-bloqueur (103) dont l'entrée est reliée à la sortie du deuxième générateur de fonction, et des moyens (133) pour faire passer ce troisième échantillonneur-bloqueur en mode MAINTIEN lors de la réception de ladite impulsion, et pour le faire repasser en mode RECOPIE aux instants auxquels on commence à générer le signal étalon suivant.

25. Dispositif selon la revendication 24, caractérisé par le fait que les moyens pour mémoriser la valeur du deuxième signal étalon comprennent en outre un quatrième échantillonneur-bloqueur (104) dont l'entrée est reliée à la sortie du troisième échantillonneur-bloqueur, et des moyens (105) pour que le quatrième échantillonneur-bloqueur soit en mode RECOPIE lorsque le troisième échantillonneur-bloqueur est en mode MAINTIEN, et inversement.

26. Système de transmission d'un signal analogique en boucle ouverte caractérisé par le fait qu'il comprend un dispositif de conversion directe selon l'une quelconque des revendications 16 à 22 à l'entrée duquel est appliqué le signal à transmettre, un dispositif de conversion inverse selon l'une quelconque des revendications 23 à 25, et des moyens pour coupler la sortie du dispositif de conversion directe à l'entrée du dispositif de conversion inverse.

27. Système de transmission d'un signal analogique en boucle fermée, caractérisé par le fait qu'il comprend, dans sa boucle directe, un sommateur (1) pour soustraire le signal transmis du signal à transmettre, un premier dispositif de conversion directe (190) selon l'une quelconque des revendications 16 à 22, à l'entrée duquel est appliqué le signal de sortie du sommateur, un premier dispositif de conversion inverse (191), selon l'une quelconque des revendications 23 à 25, des moyens (193) pour coupler la sortie du premier dispositif de conversion directe à l'entrée du premier dispositif de conversion inverse, et des moyens (160) pour boucler la sortie du premier dispositif de conversion inverse sur lui-même.

28. Système de transmission selon la revendication 25, caractérisé par le fait que sa boucle de retour comprend un second dispositif de conversion directe (193) selon l'une quelconque des revendications 16 à 22, à l'entrée duquel est appliqué le signal transmis, un second dispositif de conversion inverse (194) selon l'une quelconque des revendications 23 à 25, dont la sortie est appliquée à l'entrée du sommateur, et des moyens (195) pour coupler la sortie du second dispositif de conversion directe à l'entrée du second dispositif de conversion inverse.

0149577

29. Système de commande d'un organe de puissance (403, 410), caractérisé par le fait qu'il comprend au moins un dispositif (401, 411) selon l'une quelconque des revendications 16 à 22, des moyens pour fournir à l'entrée de ce dispositif un signal de consigne, et des moyens (402, 412) reliés à la sortie de ce dispositif pour connecter une source d'énergie audit organe de puissance pendant la durée des impulsions de sortie de ce dispositif et pour la déconnecter en dehors desdites impulsions.

30. Système de régulation comportant une boucle directe et une boucle de retour, caractérisé par le fait que la boucle directe comprend au moins un dispositif (401,411) selon l'une quelconque des revendications 16 à 22, et des moyens (419) pour fournir, à l'entrée de ce dispositif, un signal analogique égal à la différence entre un signal de consigne et le signal de retour.

31. Système selon la revendication 30, caractérisé par le fait que lesdits moyens pour fournir le signal différence comprennent un amplificateur à gain proportionnel.

32. Système selon l'une quelconque des revendications 30 et 31, caractérisé par le fait que la boucle directe comprend également un dispositif selon l'une quelconque des revendications 23 à 25, et des moyens pour coupler la sortie du dispositif selon les revendications 16 à 22 à l'entrée du dispositif selon les revendications 23 à 25.

33. Système selon la revendication 32, rattachée à la revendication 25, caractérisé par le fait qu'un sommateur (160) est disposé entre le troisième et le quatrième échantillonneur-bloqueur pour fournir à l'entrée du quatrième échantillonneur-bloqueur un signal égal à la somme des signaux de sortie des troisième et quatrième échantillonneurs-bloqueurs.

34. Système selon l'une quelconque des revendications 30 à 33, caractérisé par le fait que la boucle de retour comprend un dispositif (404,415) selon l'une quelconque des revendications 16 à 22, un dispositif (405,416) selon l'une quelconque des revendications 23 à 25, et des moyens pour coupler la sortie du premier de ces dispositifs à l'entrée du second.

0149577

1/11

Fig. 1

Fig. 2a

Fig. 2b

Fig. 2c

2/11

0149577

Fig.3

Fig.4a

Fig.4b

Fig.4c

Fig.4d

4/11

0149577

**Fig. 5**

**Fig. 12**

**Fig. 13**

*Fig. 6a*

209

200

*Fig. 6b*

201

202

*Fig. 6c*

205 204

*Fig. 7*

*Fig. 8*

Fig. 9

8/11

0149577

Fig.10

*Fig.11*

*Fig.14*

*Fig.15*

*Fig.16*